# FASCICULE DE BREVET EUROPEEN

(11) **EP 3 323 023 B1**
(45) Date de publication et mention de la délivrance du brevet: **10.11.2021**
(21) Numéro de dépôt: 16750961.1
(22) Date de dépôt: 13.07.2016
(51) Int. Cl.: G04F 5/14

(54) **CELLULE À GAZ POUR UN CAPTEUR ATOMIQUE ET PROCÉDÉ DE REMPLISSAGE D'UNE CELLULE À GAZ**
GASZELLE FÜR EINEN ATOMSENSOR UND VERFAHREN ZUM BEFÜLLEN EINER GASZELLE
GAS CELL FOR AN ATOMIC SENSOR AND METHOD FOR FILLING A GAS CELL

(30) Priorité: 16.07.2015 FR 1556729
(43) Date de publication de la demande: 23.05.2018
(73) Titulaire: Centre National de la Recherche Scientifique (CNRS), 75016 Paris (FR); Université de Franche-Comté, 25030 Besançon Cedex (FR)
(72) Inventeur: MAURICE, Vincent, 25000 Besancon (FR); PASSILLY, Nicolas, 25870 Les Auxons (FR); GORECKI, Christophe, 70150 Pin (FR)
(74) Mandataire: Marks & Clerk France
(86) Numéro de dépôt international: PCT/FR2016/051816
(87) Numéro de publication internationale: WO 2017/009582

(56) Documents cités:
- WO-A1-2014/057229
- JP-A- 2013 007 720
- JP-A- 2015 046 535
- US-A1- 2011 232 782
- US-A1- 2014 139 294
- US-A1- 2015 061 785

## Description

L'invention concerne le domaine des cellules à gaz et des capteurs atomiques comportant des cellules à gaz. Le terme « à gaz » peut désigner un gaz quelconque, une vapeur, ou une vapeur alcaline ou un mélange d'un gaz et d'une vapeur.

Les capteurs atomiques comprennent par exemple des horloges atomiques, des micro-magnétomètres ou encore des micro-gyromètres. De tels capteurs atomiques peuvent par exemple être destinés aux systèmes de télécommunication, navigation et défense.

De telles cellules optiques à gaz sont parfois qualifiées de « cellules » ou de « microcellules » et les capteurs associés « micro-horloges atomiques », « micro-magnétomètres » et « micro-gyromètres ». Dans l'ensemble du texte, le terme « micro » doit être compris dans le contexte et avec le sens indiqué.

Une application typique est une horloge atomique à l'échelle d'une puce, connue sous l'acronyme CSAC (pour Chip-Scale Atomic Clock).

Le fonctionnement des capteurs atomiques repose sur une spectroscopie optique des atomes d'un gaz emplissant la cavité d'une cellule munie d'au moins une fenêtre optique. Cette cavité est ainsi qualifiée de « cavité optique ». Le gaz est usuellement une vapeur alcaline, comme du césium ou du rubidium. Cette spectroscopie permet de mesurer une ou plusieurs grandeurs spectrales associées à la ou les quantités physiques que le capteur cherche à observer, par exemple une fréquence, un champ magnétique ou une accélération.

Ainsi par exemple dans le cas d'une micro-horloge atomique, le fonctionnement du capteur peut être basé sur la mesure de la fréquence d'une transition micro-onde particulière des atomes du gaz, dite transition d'horloge. Dans cette application, la micro-horloge atomique met alors typiquement en œuvre le principe de la résonnance atomique par piégeage cohérent de population connu sous l'acronyme CPT (pour Coherent Population Trapping).

Par ailleurs, la largeur de la raie observée par spectroscopie, et donc la stabilité de fréquence dans le cas d'une horloge atomique, est déterminée par le temps de relaxation des atomes alcalins à partir de l'état cohérent dans lequel ils ont été pompés vers leur état fondamental, temps qui est notamment fonction des collisions des atomes avec les parois de la cellule, qui entrainent la perte de leur cohérence.

Pour améliorer la qualité de la spectroscopie du gaz, et donc la précision et stabilité du capteur atomique, il est ainsi connu d'adjoindre à la vapeur alcaline un gaz, dit gaz tampon ou atmosphère tampon, permettant de ralentir la diffusion des atomes alcalins vers les parois de la cellule et de confiner lesdits atomes alcalins.

De tels capteurs atomiques offrent l'intérêt d'être de petites tailles, économes en énergie et de présenter une très bonne précision et stabilité de mesure.

Un exemple d'un tel capteur atomique est connu des travaux du consortium MAC-TFC, l'institut FEMTO-ST (acronyme pour Franche-Comté Electronique Mécanique Thermique et Optique - Sciences et Technologies) qui a conçu et réalisé une cellule à vapeur de césium très compacte (quelques mm3) pour une horloge atomique, avec micro-usinage MEMS (acronyme pour MicroElectroMechanical Systems) du silicium et soudure anodique (voir par exemple « New approach of fabrication and dispensing of micromachined césium vapor cell » de L. Nieradko, C. Gorecki, A. Douahi, V. Giordano, J.C. Beugnot, J. Dziuban et M. Moraja publié dans JOURNAL OF MICRO-NANOLITHOGRAPHY MEMS AND MOEMS d'août 2008).

La réalisation de cellules optiques à gaz et de tels capteurs atomiques fait usuellement appel aux méthodes de microfabrication d'empilements de substrats de silicium et de verre, fixés entre eux par des soudures anodiques.

Un procédé habituel de microfabrication d'une cellule commence ainsi par la gravure de cavités dans un substrat de silicium. Un premier substrat de verre est ensuite soudé, usuellement par soudure anodique, d'un côté de ce substrat. Enfin, un deuxième substrat de verre est soudé sur la face opposée après incorporation d l'atmosphère tampon et du métal alcalin, qui peut prendre diverses formes selon la méthode de remplissage employée.

Pour introduire le métal alcalin dans la cavité optique, on peut réaliser la fabrication, et notamment l'étape de soudure anodique, dans une atmosphère contenant du césium et un gaz tampon ou en déposant une certaine quantité de métal alcalin sous forme liquide ou solide dans une cavité de la cellule.

Toutefois le scellement en présence de césium pur apporte des complications. La soudure anodique doit en effet débuter à basse température, pour éviter l'évaporation de métal déposé dans la cavité, et continuer pendant que la température est augmentée. Ceci peut mener à des disparités de pression du gaz tampon comme indiqué dans le document US2012/0298295A1. Le problème de l'évaporation de métaux comme le césium ou le rubidium aux températures de soudure lors du scellement de cellules à vapeur par soudure anodique est connu et est adressé dans le document JP 2015/046535. En particulier, ce document divulgue une cellule à gaz pour une horloge atomique, la cellule étant associée d'une part, à au moins un laser d'émission d'un faisceau laser extérieur entrant impactant la cellule et, d'autre part, à un photodétecteur de réception d'un faisceau laser extérieur sortant de la cellule, le faisceau laser ayant pénétré la cellule, la cellule comprenant une cavité optique munie d'au moins une fenêtre optique et apte à être emplie d'un gaz.

La cellule décrite dans ce document comprend en outre une cuvette de scellement comportant une embouchure de cavité adaptée pour permettre un passage de gaz entre la cuvette de scellement et la cavité optique, et aussi une embouchure de canal conçue pour permettre une arrivée de gaz dans la cuvette de scellement par un canal d'arrivée de gaz.

Cette cellule comporte un accès de scellage ainsi qu'un ensemble multicouche comportant, d'une part, une plaquette - ou wafer
- conformable, conformée en creux pour présenter un évidement débouchant en au moins une ouverture, ledit évidement étant apte à être empli d'un gaz, et, d'autre part, au moins une plaquette
- ou wafer - en verre fermant hermétiquement ladite ouverture de l'évidement pour former une cavité optique munie d'au moins une fenêtre optique, la plaquette - ou wafer - en verre et la plaquette - ou wafer - conformée en creux étant disposées en regard l'une de l'autre et scellées l'une à l'autre.

Enfin, ce document divulgue aussi une membrane métallique pour sceller la cuvette et la séparer du réservoir. Ce scellement est effectué par fusion d'un élément de scellement et de la membrane 236.

Pour simplifier la fabrication du capteur atomique et permettre la mise en œuvre d'un équipement de soudure anodique standard dans les conditions optimales, il est connu d'utiliser un composé solide appelé dispenseur qui est introduit dans la cellule lors de l'étape de scellement. Un tel composé est par exemple constitué d'un alliage Zr-Al et de chromate de césium, approprié pour rester stable à la température de la soudure anodique. Le dispenseur est ensuite chauffé localement, par exemple à l'aide d'un laser de puissance afin de libérer du césium pur et d'établir une vapeur saturée dans la cellule. Après activation la plupart des atomes de césium sont en phase liquide ou en phase solide, en fonction de la température. Une telle méthode est par exemple détaillée dans le document « From the Implementation to the Characterisation and Assembling of Microfabricated Optical Alkali Vapor Cell for MEMS Atomic Clocks. » de Nieradko, Lukasz, et al., paru en 2007 dans la revue Solid-State Sensors, pages 45-48.

Si elle simplifie la fabrication du capteur, la présence d'un dispenseur dans chaque cellule est toutefois également contraignante. D'une part, elle limite la densité de cellules réalisables sur un wafer, ce qui augmente le coût de production par cellule. D'autre part, elle augmente la taille de la cellule, et par conséquent celle du capteur atomique qui l'intègre. La cellule pâtit également d'une dissipation thermique plus importante (surface radiante plus grande). Par ailleurs, l'utilisation d'un dispenseur par cellule impose un coût fixe non négligeable pour chaque cellule. La quantité de césium libérée lors de l'activation par chauffage est également difficile à contrôler. La quantité de métal alcalin peut ainsi varier de façon importante entre des cellules provenant d'un même lot de fabrication. La condensation de césium peut alors être excessive et obstruer la fenêtre optique, ou à l'inverse, la quantité de césium peut être insuffisante pour garantir une durée de vie satisfaisante. Par ailleurs, une étude a indiqué que le dispenseur pouvait provoquer des variations de l'atmosphère et compromettre les performances de l'horloge qui l'intègre (« Aging Study on a MicroFabricated Cs Buffer-Gas Cell for Atomic Clock Applications. » de Abdullah, Salman et al. paru en 2014 dans Proc. European Frequency and Time Forum). Enfin, le dispenseur n'étant usuellement pas fixé dans la cavité, il peut heurter les parois si la cellule est soumise à des chocs ou à des vibrations. Les particules qui composent le dispenseur peuvent alors se désagréger et venir obstruer la fenêtre optique.

L'un des objectifs de l'invention est ainsi d'éviter la présence d'un dispenseur dans la cellule finale ou d'empêcher les interactions entre le dispenser et l'atmosphère de la cavité optique

Le gaz tampon adjoint dans la cellule peut être composé d'une ou de plusieurs espèces atomiques ou moléculaires.

Cependant, la présence d'une atmosphère tampon présente l'inconvénient d'introduire une dépendance de la mesure spectroscopique en fonction de la température de la cellule (par exemple une dépendance quadratique de la fréquence de la transition d'horloge avec la température).

Ainsi, des variations de température de la cellule se traduisent par des variations des grandeurs spectrales mesurées et donc de la mesure du capteur atomique.

Il est donc nécessaire d'utiliser une atmosphère tampon pour laquelle la dépendance thermique induite sur les grandeurs spectrales présente un point d'inversion autour de la température de fonctionnement de la cellule.

On connait notamment du document « Quadratic Dependence on Temperature of Cs 0-0 Hyperfine Resonance Frequency in Single Ne Buffer Gas Microfabricated Vapour Cell. » de Miletic, Danijela et al., paru en 2010 dans la revue Electronics Letters vol. 46 une atmosphère tampon composée uniquement de néon qui permet d'annuler la dépendance thermique de la fréquence de la transition horloge autour de 80 °C.

Une telle atmosphère tampon permet de faire fonctionner le capteur atomique dans une plage de température limitée à quelques degrés en dessous de la température de fonctionnement de la cellule, soit par exemple jusqu'à 70-75 °C pour une atmosphère tampon de néon pur car les contraintes énergétiques permettent usuellement uniquement de chauffer la cellule sans pouvoir la refroidir et l'électronique associée dissipe également de l'énergie sous forme de chaleur.

Pour répondre aux standards industriels actuels, ces systèmes doivent pourtant pouvoir fonctionner dans une plage allant de -40 °C à +85 °C, voir au-delà pour certaines applications.

On connait par ailleurs des atmosphères tampon composées de diazote et d'argon qui permettent, en ajustant les pressions partielles du mélange, d'obtenir un point d'inversion variable jusqu'à 120 °C comme cela est décrit dans le document « RF-Interrogated End-State Chip-Scale Atomic Clock. » de Braun, Alan M et al., paru en 2007 dans les 39th Annual Precise Time and Time Interval Meeting.

L'utilisation du diazote avec un dispenseur présente toutefois des inconvénients car le diazote est absorbé par le dispenseur.

D'autres atmosphères tampon composées de gaz rares, qui ne réagissent pas avec le dispenseur, ont également été étudiées mais présentent des inconvénients. Ainsi ces mélanges sont difficiles à contenir de manière stable, imposent un élargissement spectrale défavorable et sont de manière générale moins favorables que le diazote pour atténuer l'effet de « radiation trapping » qui réduit la qualité du signal et les performances du capteur.

Un autre but de l'invention est ainsi notamment de permettre l'utilisation, dans une cellule à vapeur, d'une diversité de gaz tampon sans que le fonctionnement ou la fabrication de la cellule à vapeur ne présente les inconvénients détaillés ci-avant.

Enfin, lors du procédé de soudure anodique, des molécules composées d'oxygène peuvent être générées. Les procédés existants ne permettent donc pas d'atteindre des niveaux de vide inférieurs à 10⁻⁴ mbar, qui sont nécessaires pour des applications comme le piégeage magnéto-optique d'atomes ou le piégeage d'ions.

Encore un autre but de l'invention est ainsi notamment d'améliorer la qualité du vide par rapport à ce qui est usuellement obtenu lors d'un scellement par soudure anodique.

L'invention a ainsi pour premier objet une cellule à gaz, destinée notamment à être incluse dans un capteur atomique tel qu'une horloge atomique, un magnétomètre atomique ou un gyromètre atomique. La cellule selon l'invention est définie dans la revendication indépendante 1.

Selon une réalisation, la cellule comprend en outre un dispositif de chauffe en contact avec la membrane, notamment un élément résistif apte à être parcouru par un courant électrique ou une couche d'un matériau absorbant pour au moins une longueur d'onde lumineuse qui n'est pas sensiblement absorbée par la membrane.

Selon une réalisation, la fenêtre optique et la membrane sont formées par deux portions écartées l'une de l'autre d'une seule et même plaquette - ou wafer - en verre.

Selon une réalisation, la plaquette - ou wafer - conformable est conformée en creux pour présenter un deuxième évidement, formant la cuvette de scellement, et débouchant en au moins une deuxième ouverture, formant l'accès de scellage.

Selon une réalisation, la cuvette de scellement et la membrane sont formées dans la plaquette - ou wafer - en verre, en particulier la plaquette - ou wafer - en verre comporte au moins une première sous-couche en verre et une deuxième sous-couche en verre superposées et solidarisées, la cuvette de scellement étant formée dans la première sous-couche en verre, la membrane étant formée dans la deuxième sous-couche en verre.

Selon une réalisation, le canal d'arrivée de gaz est formé dans l'une au moins de la plaquette - ou wafer - conformable et de la plaquette - ou wafer - en verre, de sorte à traverser sensiblement la totalité d'une épaisseur de ladite plaquette - ou wafer -, de manière sensiblement perpendiculaire à un plan d'extension de ladite plaquette - ou wafer.

Selon une réalisation, la membrane est en verre, et en particulier est une portion amincie d'une plaquette - ou wafer - en verre.

Selon une réalisation, la cuvette de scellement comporte une zone de scellage entourant l'embouchure de canal, sensiblement plane et parallèle à la membrane non déformée, et conçue pour venir former un contact hermétique avec la membrane déformée plastiquement par chauffage de sorte à séparer hermétiquement la cavité optique du canal d'arrivée de gaz.

Selon une réalisation, une distance entre la membrane non déformée plastiquement et la zone de scellage - mesurée perpendiculairement à ladite membrane non déformée plastiquement et ladite zone de scellage - est inférieure à une centaine de microns.

Selon une réalisation, un diamètre de la zone de scellage de la cuvette de scellement est supérieur à trois fois ladite distance entre la membrane non déformée plastiquement et la zone de scellage.

Selon une réalisation, une épaisseur de la membrane est inférieure à 500 microns, de préférence inférieure à 100 microns.

Selon une réalisation, la cellule comprend une source d'un gaz reliée au canal d'arrivée de gaz et adaptée pour emplir la cavité optique avec un gaz par l'intermédiaire du canal d'arrivée de gaz et de la cuvette de scellement, au moyen de l'embouchure de cavité et de l'embouchure de canal.

Selon une réalisation, la source comprend une cavité source reliée au canal d'arrivée de gaz et un dispenseur de métal alcalin reçu dans la cavité source et adapté pour générer une vapeur alcaline par chauffage.

Selon une réalisation, la cellule comprend, outre la cavité optique, une cavité additionnelle emplie d'un gaz additionnel, adjacente à et séparée de la cavité optique par une paroi conçue pour être percée et permettre un mélange dudit gaz additionnel avec un gaz contenu dans la cavité optique.

Selon une réalisation, la paroi de la cavité additionnelle est apte à être percée par une action sans contact exogène à la cellule 2, notamment par une interaction avec la paroi d'un faisceau laser impulsionnel, d'un faisceau laser continu ou d'une décharge électrique.

Selon une réalisation, la cavité optique est emplie d'un gaz, et la membrane est dans un état déformé plastiquement dans lequel la membrane ferme hermétiquement au moins l'une parmi l'embouchure de cavité et l'embouchure de canal, en séparant hermétiquement la cavité optique du canal d'arrivée de gaz.

L'invention a également pour objet un ensemble de cellules comportant une pluralité de cellules telle que décrites ci-avant, dont les canaux d'arrivée de gaz sont reliés à une unique source de gaz, en particulier dans lequel ladite pluralité de cellules forme un ensemble solidaire et rigide adapté pour être découpé de sorte à séparer les cellules les unes des autres.

L'invention a encore pour objet un procédé d'emplissage de gaz d'une cellule, dans lequel :
- on dispose d'une cellule telle que décrite ci-avant ou d'un ensemble de cellules tel que décrit ci-avant,
- on dispose d'une source d'un gaz reliée au canal d'arrivée de gaz de la cellule ou de l'ensemble de cellules,
- on emplit la cavité optique avec le gaz de la source par l'intermédiaire du canal d'arrivée de gaz et de la cuvette de scellement, au moyen de l'embouchure de cavité et de l'embouchure de canal, et
- on déforme plastiquement par chauffage la membrane pour venir fermer hermétiquement au moins l'une parmi l'embouchure de cavité et l'embouchure de canal, de sorte à séparer hermétiquement la cavité optique du canal d'arrivée de gaz.

Selon une réalisation, on déforme plastiquement la membrane par chauffage au moyen d'un laser dirigé sur la membrane.

Selon une réalisation, on déforme plastiquement la membrane par chauffage en faisant circuler un courant électrique dans un élément résistif en contact avec la membrane.

Selon une réalisation, la source est un dispenseur de métal alcalin reçu dans une cavité source reliée au canal d'arrivée de gaz de la cellule ou de l'ensemble de cellules, et on emplit la cavité optique en chauffant ledit dispenseur.

Selon une réalisation, après avoir déformé plastiquement la membrane pour séparer hermétiquement la cavité optique du canal d'arrivée de gaz, on sépare la cellule de la source de gaz.

Selon une réalisation, après avoir déformé plastiquement la membrane pour séparer hermétiquement la cavité optique du canal d'arrivée de gaz, on perce une paroi séparant de la cavité optique une cavité additionnelle emplie d'un gaz additionnel, de sorte à mélanger ledit gaz additionnel avec un gaz contenu dans la cavité optique.

L'invention a encore pour objet un procédé de mise sous vide d'une cellule, dans lequel :
- on dispose d'une cellule telle que décrite ci-avant ou d'un ensemble de cellules tel que décrit ci-avant,
- on dispose d'une station de pompage reliée au canal d'arrivée de gaz de la cellule ou de l'ensemble de cellules,
- on actionne la station de pompage pour aspirer un gaz contenu dans la cavité optique par l'intermédiaire du canal d'arrivée de gaz et de la cuvette de scellement, au moyen de l'embouchure de cavité et de l'embouchure de canal, et
- on déforme plastiquement par chauffage la membrane pour venir fermer hermétiquement au moins l'une parmi l'embouchure de cavité et l'embouchure de canal, de sorte à séparer hermétiquement la cavité optique du canal d'arrivée de gaz.

L'invention a encore pour objet un procédé de fabrication d'une cellule ce procédé étant défini dans la revendication indépendante 29.

L'invention a enfin pour objet un capteur atomique comprenant une cellule telle que décrite ci-avant, associée, de façon compacte, d'une part, à un laser d'émission d'un faisceau laser extérieur entrant impactant la cellule et, d'autre part, à un photodétecteur de réception d'un faisceau laser extérieur sortant de la cellule.Sur les dessins :

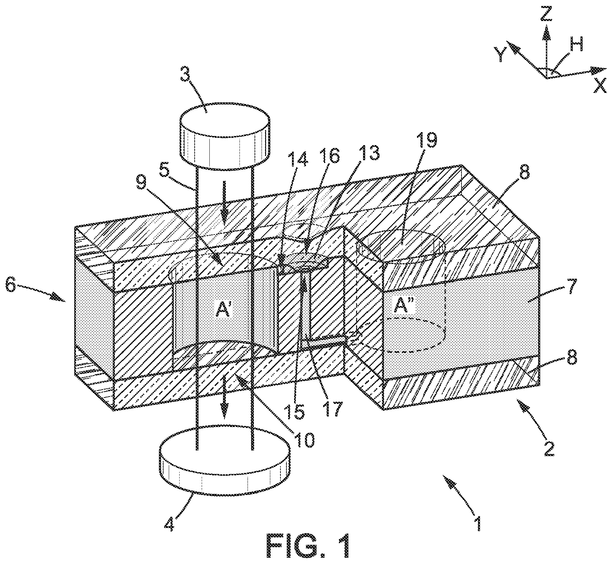

- la figure 1 est un schéma en perspective et en coupe d'un capteur atomique selon un mode de réalisation de l'invention, comportant une cellule à gaz selon un mode de réalisation de l'invention, à laquelle sont associés un laser d'émission d'un faisceau laser entrant impactant la cellule et un photodétecteur de réception d'un faisceau laser extérieur sortant de la cellule,

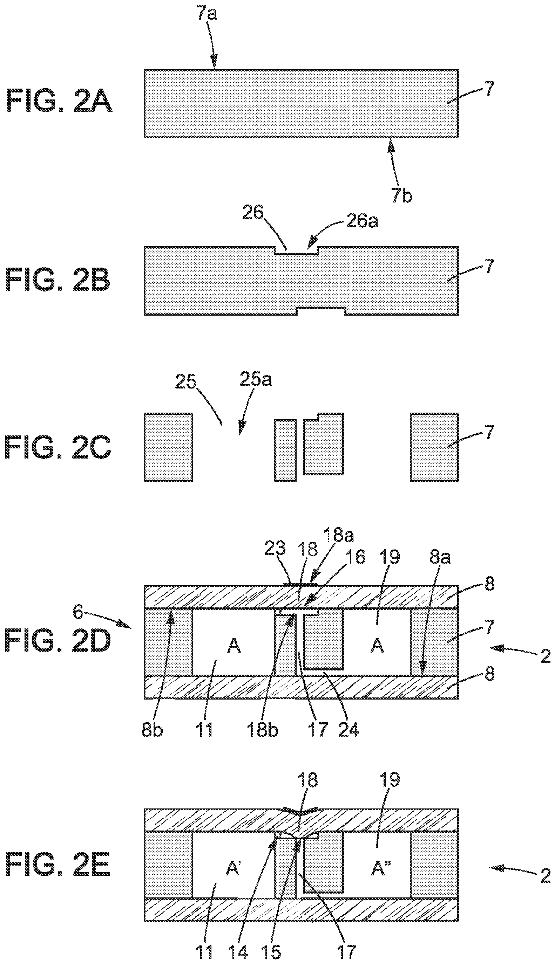

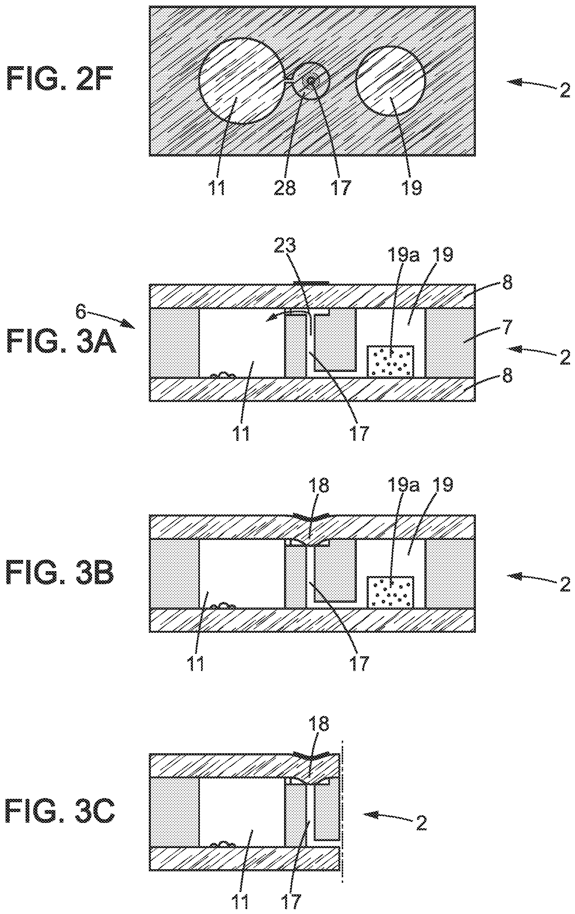

- les figures 2A à 2F illustrent les étapes successives d'un procédé de réalisation d'une cellule telle que celle représentée sur la figure 1 selon une coupe transversale pour les figures 2A à 2E et une vue de dessus pour la figure 2F ; les figures 2A à 2C illustrent plus spécialement la conformation d'une plaquette - ou wafer - conformable, la figure 2D, l'assemblage de la plaquette - ou wafer - conformable et de plaquette - ou wafer - en verre pour former un ensemble multicouche et réaliser la cellule proprement dite, la figure 2E le scellement de la cellule après emplissage de gaz par déformation de la membrane et la figure 2F illustre une vue de dessus de la cellule de la figure 2E,
- les figures 3A à 3C illustrent les étapes successives d'un procédé d'emplissage de gaz d'une cellule telle que celle représentée sur les figures 1 et les figures 2A à 2E ; la figure 3A illustre plus spécialement l'emplissage de gaz de la cavité optique, la figure 3B le scellement de la cellule après emplissage par déformation de la membrane et la figure 3C la séparation de la cellule de la source de métal alcalin,

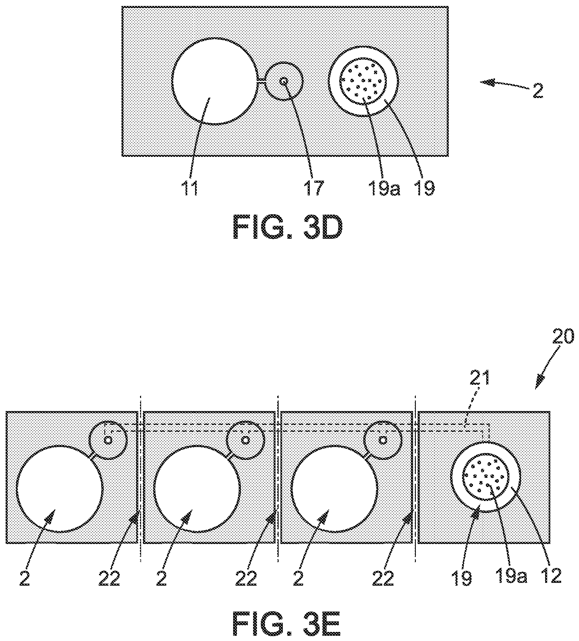

- la figure 3D illustre une vue de dessus de la cellule de la figure 3B,
- la figure 3E illustre une vue de dessus d'un ensemble de cellules comportant une pluralité de cellules telles que celle des figures 3A à 3D,

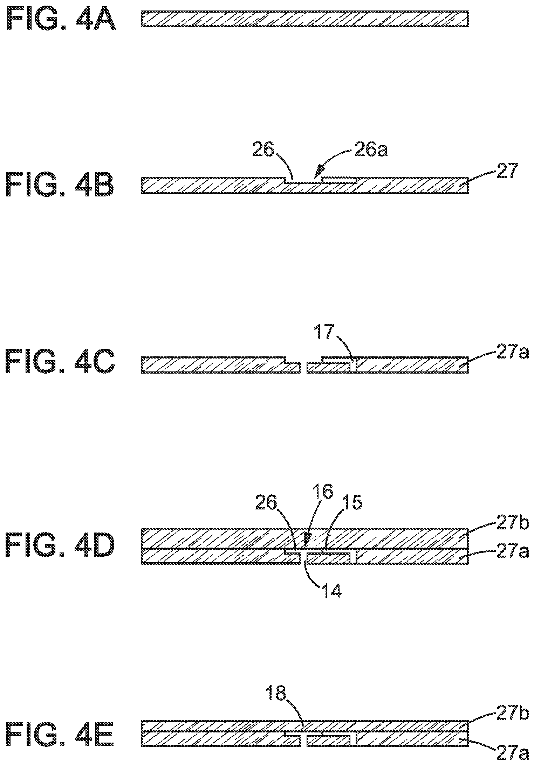

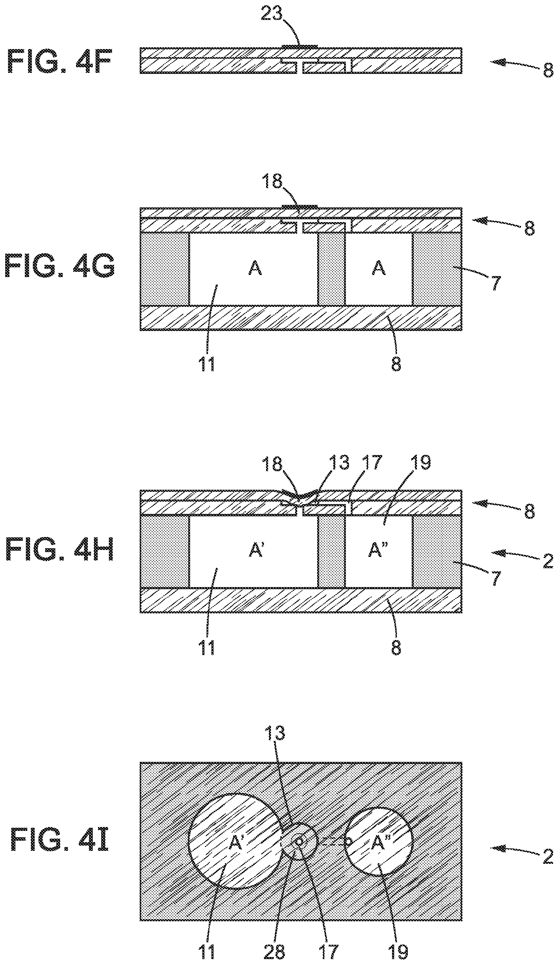

- les figures 4A à 4I illustrent les étapes successives d'un procédé de réalisation d'une cellule selon un deuxième mode de réalisation de l'invention dans lequel la cuvette de scellement et la membrane sont définies dans la plaquette - ou wafer - de verre, selon une coupe transversale pour les figures 4A à 4H et une vue de dessus pour la figure 4I ; les figures 4A à 4F illustrent plus spécialement la définition de la cuvette de scellement et de la membrane dans les première sous-couche en verre et deuxième sous-couche en verre d'une plaquette - ou wafer - en verre, la figure 4G, l'assemblage d'une plaquette - ou wafer - conformable et de la plaquette - ou wafer - en verre pour former un ensemble multicouche et réaliser la cellule proprement dite, la figure 4H le scellement de la cellule après emplissage de gaz par déformation de la membrane et la figure 4I illustre une vue de dessus de la cellule de la figure 4H,

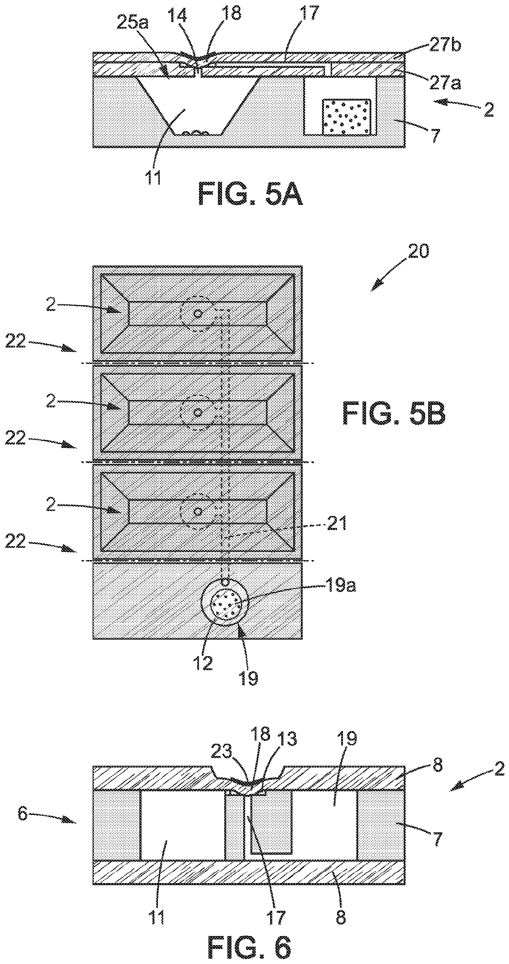

- la figure 5A illustre une vue en coupe d'une variante de réalisation d'une cellule selon le mode de réalisation des figures 4A à 4I, dans laquelle la cavité optique est non traversante et de forme pyramidale,
- la figure 5B illustre une vue de dessus d'un ensemble de cellules comportant une pluralité de cellules telles que celle de la figure 5A,
- la figure 6 illustre une vue en coupe d'une variante de réalisation d'une cellule selon le mode de réalisation des figures 1 et 2A à 2E, dans laquelle la membrane est une portion amincie d'une plaquette - ou wafer - en verre,

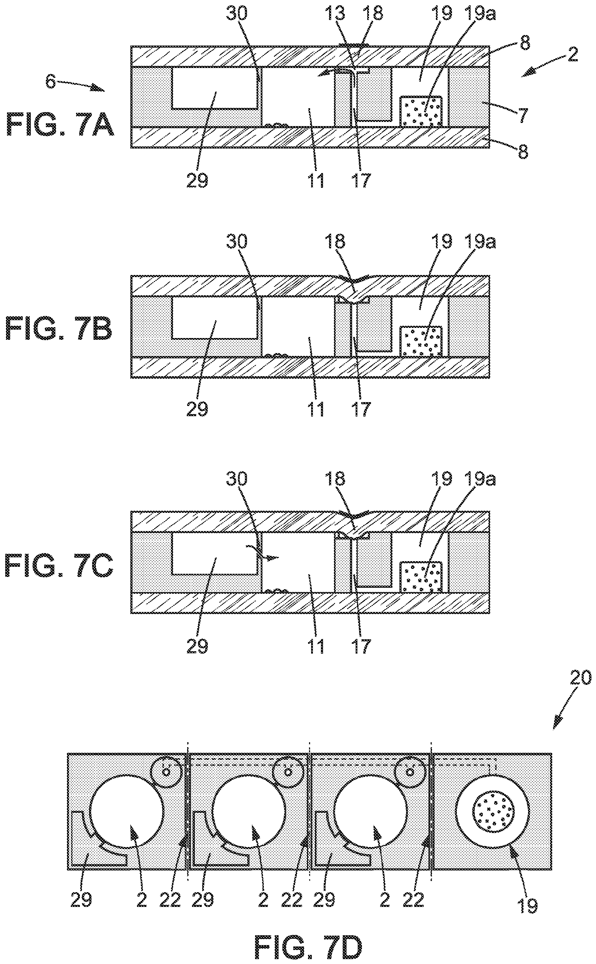

- les figures 7A à 7C illustrent les étapes successives d'un procédé d'emplissage de gaz d'une cellule selon une variante de réalisation d'une cellule telle que celle des figures 1 et 2A à 2E, dans laquelle la cellule comporte une cavité additionnelle emplie de gaz additionnel, la figure 7A illustre plus spécialement l'emplissage de gaz de la cavité optique, la figure 7B le scellement de la cellule après emplissage par déformation de la membrane et la figure 7C le perçage de la paroi séparant la cavité additionnelle de la cavité optique pour mélanger le gaz additionnel et le gaz de la cavité optique,
- la figure 7D illustre une vue de dessus d'un ensemble de cellules comportant une pluralité de cellules telles que celle des figures 7A à 7C,

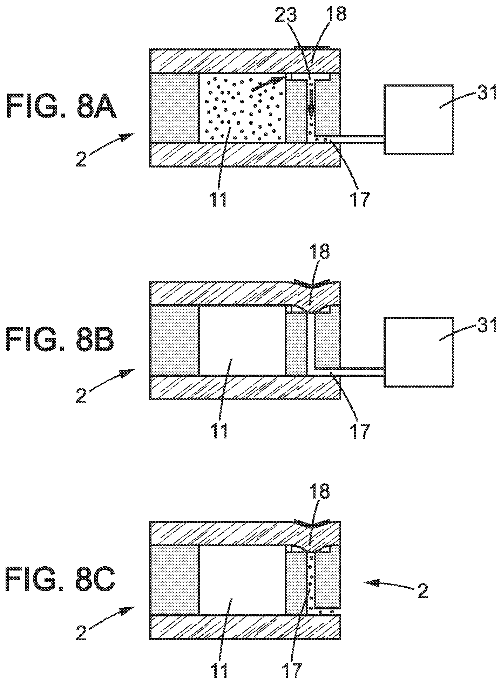

- les figures 8A à 8C illustrent les étapes successives d'un procédé de mise sous vide d'une cellule selon un mode de réalisation de l'invention, la figure 8A illustre plus spécialement l'actionnement d'une station de pompage pour aspirer un gaz contenu dans la cavité optique, la figure 8B le scellement de la cellule après mise sous vide par déformation de la membrane et la figure 8C la séparation de la cellule de la station de pompage ;

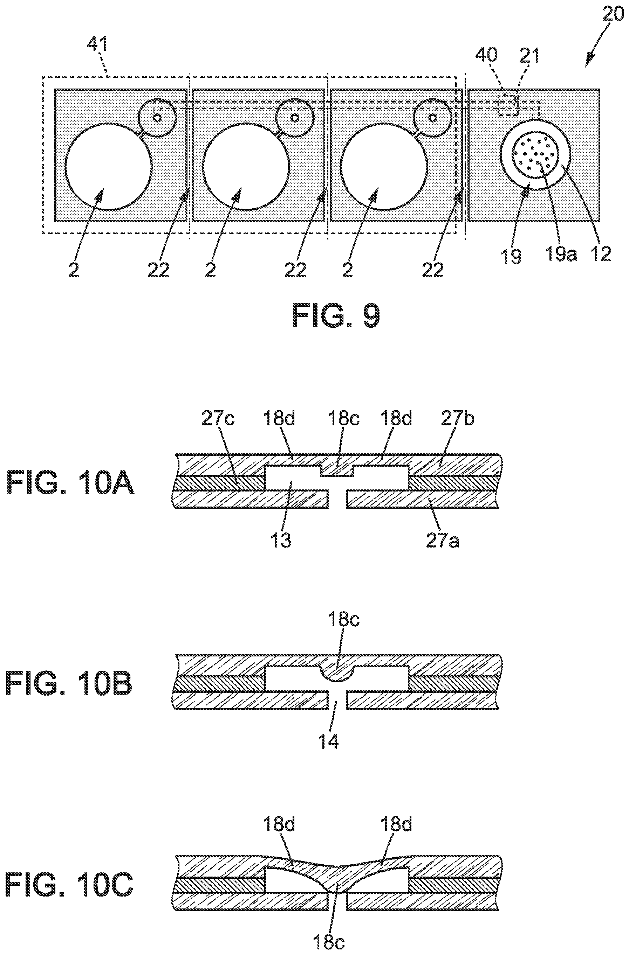

- la figure 9 illustre une vue de dessus d'un ensemble de cellules comportant une pluralité de cellules telles que celle des figures 3A à 3D lors de la mise en œuvre d'une mode de réalisation d'un procédé d'emplissage de gaz selon l'invention,
- les figures 10A à 10C illustrent les étapes successives d'un procédé d'emplissage de gaz d'une cellule selon deux variantes combinées de réalisation d'une cellule dans lesquelles la membrane de la cellule comporte une excroissance et la cellule comporte un ensemble multicouche comprenant une première sous-couche en verre, une couche intermédiaire et une deuxième sous-couche en verre, la figure 10A illustre plus spécialement l'emplissage de gaz de la cavité optique et les figures 10B et 10C le scellement de la cellule après emplissage par déformation de la membrane.

Sur les différentes figures, les mêmes références désignent des éléments identiques ou similaires.

La figure 1 illustre un exemple d'un capteur atomique 1 selon l'invention incorporant une cellule 2.

Le capteur atomique 1 est par exemple une horloge atomique à l'échelle d'une puce (CSAC pour Chip-Scale Atomic Clock) reposant sur le principe de la résonnance atomique par piégeage cohérent de population (CPT pour Coherent Population Trapping). Le capteur atomique 1 comprend une cellule 2 à vapeur alcaline (césium) à laquelle sont associés, d'une part, à un laser 3 d'émission d'un faisceau laser extérieur entrant impactant la cellule 2, par exemple un laser à cavité verticale (VCSEL pour Vertical Cavity Surface Emitting Laser) et, d'autre part, à un photodétecteur de réception 4 d'un faisceau laser extérieur sortant de la cellule 2. On désigne par 5, le faisceau laser.

La cellule 2 comprend tout d'abord une cavité optique 11 qui est munie d'au moins une fenêtre optique 9 et est apte à être emplie d'un gaz.

Le gaz comprend par exemple une vapeur alcaline comme du césium ou du rubidium et, le cas échéant un gaz tampon.

À cette fin, la cellule 2 comprend d'une part un ensemble multicouche 6 qui prend par exemple la forme d'un boitier 6. Cet ensemble multicouche 6 inclut, en premier lieu, une plaquette - ou wafer - 7, dénommée « plaquette - ou wafer - 7 conformable » ou bien « plaquette - ou wafer - 7 conformée en creux », selon qu'on la considère à l'état originel non conformé ou à l'état conformé, étant donné qu'elle est in fine conformée en creux comme il est exposé.

La plaquette - ou wafer - 7 s'étend selon une plan d'extension H entre une première face 7a et une deuxième face 7b, opposées l'une à l'autre et sensiblement parallèles au plan d'extension H.

Comme illustré par les figures 2A à 2C, la plaquette - ou wafer - 7 est conformée en creux pour présenter un évidement 25 sur au moins l'une de ses faces 7a, 7b, débouchant en au moins une ouverture 25a, sur au moins l'une de ses faces 7a, 7b.

L'évidement 25 se comprend relativement à un plan de base frontal S la plaquette - ou wafer - 7, sur lequel est appliquée la plaquette - ou wafer - en verre 8, par exemple à la première face 7a.

Pour former l'évidement 25, la plaquette - ou wafer - 7 conformable peut être gravée, notamment gravée par l'ouverture 25a de l'évidement 25. L'évidement 25 peut par exemple être formé par gravure ionique réactive profonde ou par gravure humique anisotrope KOH.

L'évidement 25 est apte à être empli d'un gaz pour former une portion de la cavité optique 11.

L'ensemble multicouche 6 inclut, en second lieu, au moins une plaquette - ou wafer - en verre 8 qui est formée d'une seule plaquette ou de plusieurs plaquettes superposées comme cela sera détaillé plus loin.

La plaquette - ou wafer - en verre 8 est disposée pour fermer hermétiquement l'ouverture 25a de l'évidement 25 de sorte à former, avec ledit évidement 25, la cavité optique 11 munie d'au moins une fenêtre optique.

À cette fin, la plaquette - ou wafer - conformée en creux 7 et la plaquette - ou wafer - en verre 8 sont disposées en regard l'une de l'autre, l'une contre l'autre.

La plaquette - ou wafer - en verre 8 s'étend par exemple également selon une plan d'extension H entre une première face 8a et une deuxième face 8b, opposées l'une à l'autre et sensiblement parallèles au plan d'extension H.

Une face 8a, 8b de la plaquette - ou wafer - en verre 8 est ainsi disposée en regard et en contact avec une face 7a, 7b de la plaquette - ou wafer - 7.

Les plaquettes 7, 8 sont scellées l'une à l'autre, de façon fixe et étanche, en particulier par soudure anodique entre leurs faces en regard.

L'ensemble multicouche 6 (et donc par extension la cellule 2) peut avoir une forme extérieure parallélépipédique ou cylindrique ou une autre forme. Il est généralement aplati et compact moyennant un volume qui peut être de quelques mm3 ou de quelques dizaines de mm3. Il présente un plan d'extension H, et deux plans transversaux perpendiculaires, à savoir un premier plan transversal qui est le plan des figures 2A à 2E (et le plan médian de la cavité optique 11) et un second plan médian transversal perpendiculaire.

La cellule 2 comporte ainsi au moins une fenêtre optique 9 formée par une portion de la plaquette - ou wafer - en verre 8.

La cellule 2 peut également comporter une deuxième fenêtre optique 10 qui peut être disposée du même côté de la cellule 2 que la fenêtre optique 9, les deux fenêtres optiques étant par exemple formées par deux portions écartées l'une de l'autre de la plaquette - ou wafer - en verre 8.

Alternativement, la deuxième fenêtre optique 10 peut être disposée d'un côté de la cellule 2 opposé au côté de la fenêtre optique 9, les deux fenêtres optiques étant formées par deux plaquettes - ou wafer - en verre 8 distinctes, placées sur des faces 7a, 7b respectivement opposées de la plaquette - ou wafer - conformée en creux 7.

La cellule 2 comprend par ailleurs une cuvette de scellement 13.

La cuvette de scellement 13 est munie d'une embouchure de cavité 14, d'une embouchure de canal 15 et d'un accès de scellage 16.

L'embouchure de cavité 14 est adaptée pour permettre un passage de gaz entre la cuvette de scellement 13 et la cavité optique 11.

L'embouchure de canal 15 est conçue pour permettre une arrivée de gaz dans la cuvette de scellement 13 par un canal d'arrivée de gaz 17.

Enfin, l'accès de scellage 16 est fermé hermétiquement par une membrane 18 illustrée sur la figure 2D.

La membrane 18 est apte à être déformée plastiquement par chauffage pour venir fermer hermétiquement au moins l'une parmi l'embouchure de cavité 14 et l'embouchure de canal 15, de sorte à séparer hermétiquement la cavité optique 11 du canal d'arrivée de gaz 17.

La membrane 18 peut notamment être en verre de sorte à pouvoir être déformée plastiquement de manière aisée et à assurer une fermeture hermétique au gaz d'au moins l'une parmi l'embouchure de cavité 14 et l'embouchure de canal 15.

Plus précisément, la membrane 18 est apte à être placée, en premier lieu, dans un état initial - ou non-déformé - illustré sur les figures 2D, 3A, 4G, 7A et 8A.

Dans cet état initial, la membrane 18 est sensiblement plane et n'obstrue ni l'embouchure de cavité 14 ni l'embouchure de canal 15. Dans cet état de la membrane 18, il existe donc une communication entre la cavité optique 11 et le canal d'arrivée de gaz 17 par l'intermédiaire de la cuvette de scellement 13.

Il est ainsi possible d'emplir la cavité optique 11 avec un gaz amené par l'intermédiaire du canal d'arrivée de gaz 17 et de la cuvette de scellement, au moyen de l'embouchure de cavité et de l'embouchure de canal.

Ainsi par exemple, une cavité source 19 peut être reliée au canal d'arrivée de gaz 17.

Une telle cavité source 19 peut recevoir une source de métal alcalin, tel que du césium ou du rubidium, sous différentes formes.

La source de métal alcalin peut être du métal alcalin pur à l'état solide ou liquide.

La source de métal alcalin peut être un composé chimique comprenant des atomes alcalins, libérés par la suite par un post-traitement thermique ou radiatif.

La source de métal alcalin peut être un dispenseur 19a de métal alcalin, tel que du césium ou du rubidium, la vapeur alcaline étant générée par chauffage du dispenseur 19a, notamment après scellement étanche de la cellule 2 et avant déformation plastique de la membrane 18.

La cavité source 19 peut être formée dans la plaquette - ou wafer - conformable 7, par exemple en conformant en creux la plaquette - ou wafer - conformable 7 pour présenter un évidement de façon à ce qui a été décrit ci-avant concernant la cavité optique 11. La plaquette - ou wafer - 7 conformable peut ainsi être gravée par gravure ionique et/ou chimique.

La cavité source 19 peut ainsi être adjacente à la cavité optique 11, et reliée à ladite cavité optique 11 par le canal d'arrivée de gaz 17 et la cuvette de scellement 13.

Une telle cavité source 19 peut également être emplie de gaz, et reliée au canal d'arrivée de gaz 17.

Une telle cavité source 19 peut également être connectée à une source de gaz ou de métal alcalin exogène à la cellule 2 ou à l'ensemble multicouche 6.

Comme cela est illustré sur les figures 3E, 5B, 7D, une pluralité de cellules 2 peut être arrangée de telle sorte que les canaux d'arrivée de gaz 17 des cellules 2 sont reliés à une unique cavité source 19.

Une telle pluralité de cellules 2 peut alors former un ensemble 20 de cellules.

Un tel ensemble 20 de cellules peut en particulier être un ensemble unique et rigide. Les canaux d'arrivée de gaz 17 des cellules 2 peuvent être reliés à un canal commun d'arrivée de gaz 21 de l'ensemble 20. Le canal commun d'arrivée de gaz 21 peut être relié à une cavité source 19 telle que détaillée ci-avant pour une cellule 2 unique.

Ainsi par exemple, les cellules 2 de l'ensemble 20 peuvent être fabriquées à partir d'un unique ensemble multicouche 6. L'ensemble 20 peut ainsi comporter une plaquette - ou wafer - 7 conformable et au moins une plaquette - ou wafer - en verre 8 de telle sorte que les cellules optiques à vapeur 2 de l'ensemble 20 partagent ladite plaquette - ou wafer - 7 conformable et ladite au moins une plaquette - ou wafer - en verre 8.

L'ensemble 20 de cellules peut également comporter des portions de découpe 22 entre les cellules 2 de l'ensemble 20, aptes à être découpées pour permettre de séparer les cellules 2 de l'ensemble 20 après fabrication et emplissage de gaz.

Les cellules 2 de l'ensemble 20 peuvent ainsi être scellées individuellement et la quantité de césium dans chaque cellule 2 peut être contrôlée. Ceci réduit la taille et le coût de fabrication des cellules et peut améliorer les performances de l'horloge.

Un mode de réalisation particulier d'un procédé selon l'invention qui permet de garantir une quantité de condensation de césium égale et bien contrôlée dans toutes les cellules d'une pluralité de cellule est illustré sur la figure 9.

Ce procédé peut être mis en œuvre avec chacun des modes de réalisation de cellules décrits dans la présente demande, c'est-à-dire en particulier que la pluralité de cellules soit telle qu'illustré sur les figures 3E, 5B ou encore 7D.

Dans ce procédé, après emplissage de la cavité optique 11 avec le gaz (étape illustrée sur les figures 3A, 4G ou 7A), par exemple par libération de la vapeur alcaline du dispenseur 19a, on chauffe l'ensemble 20 de cellules à une température supérieure à une première température prédéfinie.

En particulier, on chauffe à la première température prédéfinie au moins une région de cavité 41 incluant chaque cavité de gaz 11 de chacune des cellules 2 de l'ensemble 20 de cellules.

Cette première température prédéfinie peut en particulier être une température élevée par rapport à la température de fonctionnement visée, par exemple 20 °C au-dessus de la température de fonctionnement visée pour le capteur atomique 1 incorporant la ou les cellules 2 de l'ensemble de cellules 20.

Comme illustré sur la figure 8, on porte par ailleurs une région 40 restreinte de l'ensemble 20 de cellules à une deuxième température prédéfinie.

La deuxième température prédéfinie est strictement inférieure à la première température prédéfinie. Par exemple la deuxième température prédéfinie est inférieure de 5°C à la première température prédéfinie.

La région 40 est ainsi une région froide par rapport au reste de l'ensemble de cellules 20.

La région 40 peut par exemple être placée en proximité de la cavité source 19.

La région 40 est une région de l'ensemble de cellules 20 qui n'appartient pas à une cavité de gaz 11 d'une cellule 2.

La région 40 peut par exemple être une portion de la plaquette - ou wafer - en verre 8 située en proximité de la cavité source 19.

Le refroidissement de la région 40 peut notamment être mis en œuvre par contact avec la région 40, par exemple par contact entre un bras froid et une portion de la plaquette - ou wafer - en verre 8, éventuellement médié par un agent de conduction thermique, par exemple une graisse.

Du fait de sa température inférieure à la température du reste de l'ensemble de cellules 20, l'essentiel de la condensation générée par la fourniture du gaz par le canal commun d'arrivée de gaz 21 de l'ensemble 20 reste localisée à proximité de la région 40.

On procède ensuite, le cas échéant à la stabilisation et la passivation des surfaces des cellules 2 comme décrit par ailleurs.

Grâce à la présence de la région froide 40 à la deuxième température et de leur températures supérieures à la première température, les cavités de gaz 11 des cellules 2 de l'ensemble de cellules 20 ne contiennent pas, ou très peu, de condensation mais uniquement, ou en très grande majorité, une vapeur alcaline saturée, notamment avec une densité atomique plus importante qu'à la température opérationnelle de la cellule.

On scelle alors les cellules 2 de l'ensemble 20.

On peut ensuite refroidir l'ensemble 20 à la température opérationnelle de fonctionnement des cellules 2. La pression de vapeur saturante diminue par ce fait et l'excès de vapeur alcaline piégé dans les cavités de gaz 11 se condense dans chaque cellule 2.

La quantité de condensation ainsi piégée est bien déterminée et ne dépend que du volume de la cavité de gaz 11 et de la différence de température entre la deuxième température prédéfinie de la région 40 lors du scellement des cavités de gaz 11 et la température de fonctionnement des cellules 2.

De cette manière, on peut obtenir une quantité faible de condensation pour éviter tout risque d'obstruction optique lors du fonctionnement des cellules 2 dans un capteur atomique 1 mais une quantité de condensation suffisante pour assurer une durée de vie importante au capteur atomique 1 en remplaçant les pertes de métal alcalin. On note qu'après passivation, une petite quantité de métal alcalin est suffisante pour garantir une durée de vie importante au capteur atomique 1.

Par ailleurs, la membrane 18 est apte à être placée, en deuxième lieu, dans un état déformé, plus particulièrement un état déformé plastiquement par chauffage. Cet état déformé de la membrane 18 est illustré sur les figures 1, 2E, 3B, 3C, 4H, 5A, 6, 7B, 7C, 8B et 8C.

Dans cet état déformé, la membrane 18 vient fermer hermétiquement au moins l'une parmi l'embouchure de cavité 14 et l'embouchure de canal 15. De cette manière, la membrane 18 sépare hermétiquement la cavité optique 11 du canal d'arrivée de gaz 17.

Dans cet état déformé de la membrane 18, la cavité optique 11 est isolée du canal d'arrivée de gaz 17 et plus particulièrement isolée de l'extérieur de la cellule 2.

Ainsi, au cours d'un procédé d'emplissage de gaz selon l'invention, une fois la cavité optique 11 emplie de gaz par l'intermédiaire du canal d'arrivée de gaz 17, on déforme plastiquement par chauffage la membrane 18 pour venir fermer hermétiquement au moins l'une parmi l'embouchure de cavité 14 et l'embouchure de canal 15, de sorte à séparer hermétiquement la cavité optique 11 du canal d'arrivée de gaz 17.

Dans un mode de réalisation de l'invention, on peut déformer plastiquement la membrane 18 par chauffage au moyen d'un laser dirigé sur la membrane 18.

Pour cela, le matériau de la membrane 18 peut être tel qu'il absorbe au moins une longueur d'onde de la lumière pour être chauffé par ledit laser dirigé sur la membrane 18.

Plus précisément, la membrane peut comporter une face externe 18a de la membrane 18, opposée à une face interne 18b de la membrane 18 obstruant l'accès de scellage 16 de la cuvette de scellement 13.

La face externe 18a de la membrane 18 est ainsi par exemple une face extérieure à la cellule 2 et est donc particulièrement aisé d'accès.

La membrane 18 peut être déformée par chauffage de la face externe 18a de la membrane 18.

Ainsi par exemple un laser peut être dirigé sur la face externe 18a de la membrane 18.

Un tel laser peut par exemple être un laser à CO2 avec une longueur d'onde adaptée pour exciter la molécule du verre SiO2, par exemple 10.6 micromètres.

En variante, la membrane 18 peut être structurée de sorte à être spécialement tolérante à une irradiation laser, en particulier tolérante à une irradiation laser avec une puissance variable. Ceci est par exemple le cas avec les lasers CO2 qui présentent usuellement des variations de puissance de l'ordre de +-5%.

A cette fin, la membrane 18 peut comporter une excroissance 18c en regard de la cuvette de scellement 13 comme illustrée sur les figures 10A à 10C. L'excroissance 18c est par exemple localisée au centre de la membrane 18. L'excroissance 18c peut en particulier être placée sur la face interne 18b de la membrane 18 et de fait s'étendre dans la cuvette de scellement 13.

L'excroissance 18c constitue une réserve de verre dans la membrane permettant augmenter la capacité thermique. La portion latérale 18d de la membrane qui entoure l'excroissance 18c permet quant à elle d'assurer une déformation d'amplitude convenable à la membrane 18 comme illustré sur la figure 10C.

Dans un mode de réalisation particulier, les dimensions de l'excroissance 18c sont adaptée pour que l'excroissance puis venir pénétrer au moins partiellement dans l'une au moins parmi embouchure de cavité 14 et l'embouchure de canal 15.

Les figures 10B et 10C illustrent les états successifs de la membrane 18 lors de la déformation de ladite membrane, c'est-à-dire la fusion d'une partie de la membrane sur la figure 10B, notamment de l'excroissance 18c lorsque celle-ci est présente, et la déformation de l'ensemble de la membrane sur la figure 10C.

Alternativement, la membrane 18 peut être munie d'un dispositif de chauffe 23 permettant de chauffer et déformer plastiquement la membrane 18.

Le dispositif de chauffe 23 peut être disposé sur une face externe 18a de la membrane 18, opposée à une face interne 18b de la membrane 18 obstruant l'accès de scellage 16 de la cuvette de scellement 13.Dans une réalisation, le dispositif de chauffe 23 peut être une couche 23 d'un matériau absorbant pour au moins une longueur d'onde lumineuse qui n'est pas sensiblement absorbée par la membrane 18 de manière à concentrer localement de l'énergie en vue de l'échauffement local de la membrane.

Par « pas sensiblement absorbée par la membrane », on entend que l'absorption de la lumière à ladite longueur d'onde lumineuse, par la membrane 18, n'est pas suffisante pour déformer plastiquement la membrane 18 par chauffage sans nécessiter un laser d'une puissance rédhibitoire pour ce faire.

De cette manière, un laser dirigé sur la membrane 18 peut déformer plastiquement la membrane 18 par chauffage.

Dans un autre mode de réalisation de l'invention, on peut déformer plastiquement la membrane 18 par chauffage par effet Joules.

Pour cela, le dispositif de chauffe 23 en contact avec la membrane 18 peut être un élément résistif 23 apte à être parcourue par un courant électrique pour chauffer la membrane 18 par effet Joules.

Ledit élément résistif 23 peut par exemple être une couche d'un matériau résistif.

La cuvette de scellement 13 et la membrane 18 peuvent être réalisées de différentes manières qui vont maintenant être détaillées plus avant.

En se référant aux figures 2A à 2E, 3A à 3C, 6, 7A à 7C et 8A à 8C, la cuvette de scellement 13 peut être formée dans la plaquette - ou wafer - conformable 7.

Plus précisément, la plaquette - ou wafer - conformable 7 peut être conformée en creux pour présenter un deuxième évidement 26 débouchant sur au moins une deuxième ouverture 26a. Le deuxième évidement 26 peut alors former la cuvette de scellement 13, et la deuxième ouverture 26a former l'accès de scellage 16 de la cuvette de scellement 13.

Pour former le deuxième évidement 26, la plaquette - ou wafer - 7 conformable peut être gravée, par exemple par gravure ionique et/ou chimique, notamment par gravure par la deuxième ouverture 26a du deuxième évidement 26.

Dans un mode de réalisation de l'invention, l'évidement 25 formant une portion de la cavité optique 11 et le deuxième évidement 26 sont gravés sur une même face de la plaquette - ou wafer - 7 conformable, par exemple la première face 7a.

Dans ce mode de réalisation, l'embouchure de cavité 14 peut être formée par un recouvrement de l'évidement 25 et du deuxième évidement 26 sur la première face 7a de la plaquette - ou wafer - 7 conformable.

Dans un autre mode de réalisation, l'évidement 25 formant une portion de la cavité optique 11 et le deuxième évidement 26 peuvent être respectivement gravés sur des faces opposées de la plaquette - ou wafer - 7 conformable, respectivement sur la première face 7a et sur la deuxième face 7b.

Dans ce mode de réalisation, l'embouchure de cavité 14 peut être formée par un canal de liaison, défini dans la plaquette - ou wafer - 7 conformable, et reliant l'évidement 25 formant une portion de la cavité optique 11 et le deuxième évidement 26. Ledit canal de liaison peut notamment être défini par conformation en creux, par exemple par gravure.

Dans un dernier mode de réalisation, l'évidement 25 formant une portion de la cavité optique 11 peut être traversant et déboucher sur les deux faces 7a, 7b opposées de la plaquette - ou wafer - 7 conformable.

Dans ce mode de réalisation, l'embouchure de cavité 14 peut alors être formée par un recouvrement de l'évidement 25 et du deuxième évidement 26 sur l'une des faces 7a, 7b de la plaquette - ou wafer - 7 conformable.

Par ailleurs, le canal d'arrivée de gaz 17 peut également être défini dans la plaquette - ou wafer - 7 conformable, notamment par gravure à partir de la cuvette de scellement 13.

Le canal d'arrivée de gaz 17 peut déboucher d'une part à l'endroit de l'embouchure de canal 15 de la cuvette de scellement 13 et d'autre part à au moins une deuxième embouchure de canal 24, par exemple localisée à proximité de la cavité source 19.

Dans un mode de réalisation de l'invention illustré sur les figures 1, 2A à 2E, 3A à 3C, 6, 7A à 7C et 8A à 8C, le canal d'arrivée de gaz 17 est formé dans la plaquette - ou wafer - conformable 7 de sorte à traverser sensiblement la totalité de l'épaisseur de ladite plaquette - ou wafer - conformable 7, de manière sensiblement perpendiculaire au plan d'extension H de ladite plaquette - ou wafer - conformable 7.

Le canal d'arrivée de gaz 17 formé dans la plaquette - ou wafer - conformable 7 peut également présenter des coudes ou conformations appropriées pour atteindre la source 19.

La cuvette de scellement 13 est notamment illustrée sur les figurez 2D, 2E et 2F et peut comporter une zone de scellage 28 sensiblement plane et parallèle à la membrane 18 dans l'état non déformée.

La zone de scellage 28 entoure l'embouchure de canal 15 et est conçue pour venir former un contact hermétique au gaz avec la membrane 18 dans l'état déformée.

Dans un mode de réalisation particulier de l'invention, l'embouchure de canal 15 et la zone de scellage 28 sont sensiblement circulaires ou coronaires et concentriques et forment un fond de la cuvette de scellement 13 conformée en creux dans la plaquette - ou wafer - 7 conformable.

Une distance entre la membrane 18, dans l'état non-déformée plastiquement et la zone de scellage 28 - prise perpendiculairement à ladite membrane 18 dans l'état non-déformée et ladite zone de scellage 28 - peut notamment être inférieure à une centaine de microns, de préférence inférieure à quelques dizaines de microns.

De cette manière, la membrane 18 dans l'état déformée, peut venir aisément fermer hermétiquement l'embouchure de canal 15, de sorte à séparer hermétiquement la cavité optique 11 du canal d'arrivée de gaz 17.

Plus précisément, la cuvette de scellement 13 peut être de forme sensiblement cylindrique et peut par exemple présenter un diamètre de quelques dizaines de microns ou quelques centaines de microns.et de préférence supérieur à trois fois ladite distance entre la membrane 18, dans l'état non-déformée plastiquement et la zone de scellage 28.

Un diamètre de la zone de scellage 28 peut ainsi être supérieur à quelques dizaines de microns, par exemple supérieur à une centaine de microns.

Dans un mode de réalisation illustré sur les figures 4A à 4I, 5A à 5B, la membrane 18 peut être constituée par une portion de la plaquette - ou wafer - en verre 8.

En particulier, dans ce mode de réalisation, la fenêtre optique 9 et la membrane 18 peuvent être formées par deux portions écartées l'une de l'autre d'une seule et même plaquette - ou wafer - en verre 8.

Alternativement, la membrane 18 peut être constituée par une portion d'une deuxième plaquette - ou wafer - en verre 8. Les deux plaquettes - ou wafer - en verre 8 distinctes peuvent alors être notamment respectivement placées sur les faces 7a, 7b respectivement opposées de la plaquette - ou wafer - conformée en creux 7.

Dans la variante de réalisation de l'invention, illustré notamment sur les figures 4A à 4I, 5A et 5B, la cuvette de scellement 13 et la membrane 18 peuvent toutes les deux être formées dans la plaquette - ou wafer - en verre 8.

De cette manière, la cuvette de scellement 13 et la membrane 18 peuvent notamment être placées au-dessus de la cavité optique 11, c'est-à-dire à l'endroit de l'ouverture 25a de l'évidement 25, comme illustré sur la figure 5A.

Ceci permet de réduire encore davantage l'encombrement de la cellule 2.

Plus précisément, la plaquette - ou wafer - en verre 8 peut alors comporter au moins une première sous-couche en verre 27a et une deuxième sous-couche en verre 27b.

La première sous-couche en verre 27a et la deuxième sous-couche en verre 27b peuvent être superposées et solidarisées, de sorte à être scellées l'une à l'autre, de façon fixe et étanche, en particulier par soudure directe entre leurs faces en regard. Pour la soudure des deux substrats de verre, on peut ainsi appliquer une force importante en chauffant, et il n'est pas nécessaire de mettre en œuvre une décharge électrique.La cuvette de scellement 13 peut alors être formée dans la première sous-couche en verre 27a de manière similaire à ce qui a été décrit ci-avant concernant la plaquette - ou wafer - 7 conformable.

Ainsi, la première sous-couche en verre 27a peut être conformée en creux pour présenter le deuxième évidement 26 débouchant au en au moins une deuxième ouverture 26a. Le deuxième évidement 26 peut alors former la cuvette de scellement 13, et la deuxième ouverture 26a former l'accès de scellage 16 de la cuvette de scellement 13.

Dans ce mode de réalisation, l'embouchure de cavité 14 peut être un canal traversant la première sous-couche en verre 27a, pour déboucher en regard de la cavité optique 11 et notamment à l'endroit de l'ouverture 25a de l'évidement 25 formant une portion de la cavité optique 11.

Le canal d'arrivée de gaz 17 peut par ailleurs être défini, au moins en partie dans la première sous-couche en verre 27a de manière similaire à ce qui a été décrit ci-avant concernant la plaquette - ou wafer - 7 conformable.

La cuvette de scellement 13 et/ou le canal d'arrivée de gaz 17 définis dans la première sous-couche en verre 27a peuvent par ailleurs présenter les mêmes caractéristiques et dimensionnements que la cuvette de scellement 13 et/ou le canal d'arrivée de gaz 17 définis dans la plaquette - ou wafer - 7 conformable décrits ci-avant.

Pour former le deuxième évidement 26, la première sous-couche en verre 27a peut ainsi être gravée, par exemple par gravure ionique et/ou chimique, notamment par gravure par la deuxième ouverture 26a du deuxième évidement 26.

La membrane 18 peut alors être formée dans la deuxième sous-couche en verre 27b de manière similaire à ce qui a été décrit ci-avant en relation avec la plaquette - ou wafer - en verre 8.

Ainsi, la membrane 18 peut alors être constituée par une portion de la deuxième sous-couche en verre 27b.

Dans ce mode de réalisation, la membrane 18 déformée plastiquement peut venir fermer hermétiquement l'embouchure de cavité 14 pour séparer hermétiquement la cavité optique 11 du canal d'arrivée de gaz 17.

Une variante de ce mode de réalisation est illustrée sur les figures 10A à 10C.

Dans cette variante, l'ensemble multicouche 6 comporte en outre une couche intermédiaire 27c de scellement anodique. La couche intermédiaire 27c est disposée entre la première sous-couche en verre 27a et la deuxième sous-couche en verre 27b.

La couche intermédiaire 27c est par exemple une couche en silicium.

La couche intermédiaire 27c est adaptée pour permettre une soudure anodique entre la première sous-couche en verre 27a et la deuxième sous-couche en verre 27b. De cette manière, on évite de devoir réaliser une soudure verre sur verre entre la première sous-couche en verre 27a et la deuxième sous-couche en verre 27b.

La couche intermédiaire 27c est par exemple une couche d'une épaisseur de 100 à 200 microns.

La couche intermédiaire 27c peut être mise en forme pour laisser libre la fenêtre optique 9 de la cellule 2 de sorte à ne pas gêner le passage du faisceau laser 5 extérieur.

La couche intermédiaire 27c peut par ailleurs être mise en forme pour former une partie de la cuvette de scellement 13 et/ou une portion du canal d'arrivée de gaz 17, par exemple pour former les parois verticales de la cuvette de scellement 13 et/ou d'une portion du canal d'arrivée de gaz 17 tandis que la première sous-couche en verre 27a forme le fond de la cuvette de scellement 13 et/ou de ladite portion du canal d'arrivée de gaz 17.

Alternativement, l'ensemble de la cuvette de scellement 13 et/ou d'une portion du canal d'arrivée de gaz 17 peut être formé dans la couche intermédiaire 27c. La première sous-couche en verre 27a peut alors comporter l'embouchure de cavité 14 et/ou une portion additionnelle du canal d'arrivée de gaz 17.

Pour faciliter la déformation de la membrane 18, la membrane 18 peut notamment être une portion amincie d'une plaquette - ou wafer - en verre 8, comme illustré par la figure 6.

Par « une portion amincie d'une plaquette - ou wafer - en verre », on entend une portion amincie d'une plaquette - ou wafer - en verre 8 en totalité ou une portion amincie de la deuxième sous-couche en verre 27b d'une plaquette - ou wafer - en verre 8.

Ainsi par exemple une épaisseur de la membrane 18 peut être inférieure à quelques centaines de microns, par exemple 500 microns, voire inférieure à 200 microns, voire à une centaine de microns.

Comme cela est illustré sur les figures 7A à 7D, la cellule 2 peut en outre comporter une cavité additionnelle 29 apte à être emplie d'un gaz additionnel.

Le gaz additionnel emplissant la cavité additionnelle 29 peut notamment être un gaz tampon ou un composant du gaz tampon tel que décrit ci-avant. Le gaz additionnel peut ainsi être tel qu'il permette de ralentir la diffusion des atomes alcalins vers les parois de la cellule 2 et de confiner lesdits atomes alcalins. Le gaz additionnel peut également être tel que la dépendance des grandeurs spectrales avec la température induite par le gaz tampon présente un point d'inversion autour de la température de fonctionnement de la cellule 2.

Le gaz additionnel peut par exemple comporter du diazote et/ou de l'argon.

La cavité additionnelle 29 est adjacente à la cavité optique 11. Plus précisément, la cavité additionnelle 29 est séparée de la cavité optique 11 par une paroi 30 conçue pour être percée et permettre un mélange du gaz additionnel avec un gaz contenu dans la cavité optique 11.

De cette manière, il est possible d'emplir la cavité optique 11 par un gaz alcalin au moyen d'un dispenseur 19a, de séparer hermétiquement la cavité optique 11 du dispenseur 19a par déformation de la membrane 18, et enfin de percer la paroi 30 séparant la cavité additionnelle 29 de la cavité optique 11 de sorte à mélanger ledit gaz additionnel avec un gaz contenu dans la cavité optique 11.

De cette manière, on évite toute interaction entre le gaz additionnel et le dispenseur 19a.

Par ailleurs, si une source de métal alcalin est utilisée à la place d'un dispenseur 19a, par exemple un composé chimique à base de baryum, telle qu'un mélange de chlorure de césium et d'azoture de baryum, la réabsorption du gaz de la cavité optique 11 par le baryum est également empêchée.

Si la source de métal alcalin est de l'azoture de césium, la production indésirable de diazote supplémentaire dans la cavité optique 11 due à la décomposition involontaire de l'azoture de césium est également empêchée.

De cette manière, on évite ainsi plus généralement toute interaction entre le gaz additionnel ou le gaz contenu dans la cavité optique 11 et la source de métal alcalin provenant de la cavité source 19.

Dans un exemple de réalisation de l'invention, un élément mobile est logé dans la cavité additionnelle 29. L'élément mobile est adapté pour être déplacé par une action extérieure, par exemple par une force magnétique, pour venir percer la paroi 30 de la cavité additionnelle 29.

Dans une autre réalisation de l'invention, la paroi 30 de la cavité additionnelle 29 est apte à être percée par une action sans contact exogène à la cellule 2, notamment par une interaction avec la paroi 29 d'un faisceau laser impulsionnel, d'un faisceau laser continu ou d'une décharge électrique.

La paroi 30 peut être structurée en angle et/ou inclure des indentations de façon à favoriser son perçage ou sa rupture.

Par ailleurs, lors du perçage de la paroi, le volume occupé par le gaz additionnel et le gaz de la cavité optique 11 augmente et leurs pressions partielles respectives diminuent.

Pour une pression cible donnée, la pression de gaz additionnel à établir dans la cavité additionnelle 29 est donc supérieure à cette pression cible et dépend du volume des cavités 29 et 11. Ceci offre la possibilité d'effectuer la soudure anodique entre les plaquettes - ou wafer - de l'ensemble multicouche 6 à une pression supérieure à la pression cible (typiquement 10 kPa), ce qui augmente avantageusement la tension applicable sans créer de décharge électrique à travers le gaz.

En faisant varier le volume de la cavité additionnelle 29 entre différentes cellules 2, il est possible d'obtenir des cellules 2 de différentes pressions sur un même substrat, notamment dans un même ensemble 20 de cellules.

Ceci est utile pour corriger une inhomogénéité de pression due, par exemple, à des gradients de température lors de la soudure anodique et augmenter le rendement de production. Il est également possible de réaliser rapidement des tests d'optimisation.

Par ailleurs, en scellant les cavités additionnelles 29 avec un gaz additionnel différent du gaz source fourni par la source 19, un mélange des deux gaz est obtenu après perçage de la paroi 30. En faisant varier les rapports des volumes des cavités 29, 11 entre les cellules 2 d'un même substrat, notamment d'un même ensemble 20 de cellules, des atmosphères tampon ayant des rapports de pressions partielles différents peuvent être produites en une fois. Dans le cas où des variations du rapport des pressions partielles du gaz additionnel et du gaz source sont observées sur un même substrat, il est ainsi possible de les compenser pour augmenter le rendement de production. Cette solution présente également un intérêt pour déterminer la composition optimale d'une atmosphère tampon.

Par ailleurs, les parois de la cavité optique 11 peuvent être recouvertes d'un revêtement anti-relaxant. Un tel revêtement anti-relaxant est conçu pour limiter la perte de cohérence induite par les collisions des atomes avec les parois de la cavité optique 11.

Certains revêtements anti-relaxants ne résistent pas à la température élevée de la soudure anodique.

Selon la présente invention, un tel revêtement anti-relaxant peut alors être introduit dans la cellule 2 par le canal d'arrivée de gaz 17 et la cuvette de scellement 13, et en particulier après les étapes de soudure anodique. La membrane 18 est alors déformée plastiquement après l'introduction du revêtement anti-relaxant pour sceller la cellule 2 sans endommager le revêtement anti-relaxant.

Enfin, dans une variante de réalisation de l'invention, le canal d'arrivée de gaz 17 de la cellule 2 peut être relié à une station de pompage 31 apte à aspirer un gaz contenu dans la cavité optique 11.

Un procédé de mise sous vide d'une cellule 2 peut ainsi comporter l'actionnement de la station de pompage 31 pour aspirer un gaz contenu dans la cavité optique 11.

Après que l'actionnement de ladite station de pompage 31 ait permis d'atteindre, dans la cavité optique 11, un vide jugé suffisant, le canal d'arrivée de gaz 17 peut alors être séparé de la cavité optique 11 par déformation de la membrane 18.

Par « vide », on entend une pression inférieure à la pression atmosphérique et avantageusement inférieure à 10⁻⁴ mbar.

La station de pompage 31 peut notamment être actionnée après les étapes de soudure anodique.

De cette manière, il est possible d'atteindre les conditions nécessaires pour le piégeage magnéto-optique d'atomes ou le piégeage d'ions.

## Revendications

1. Cellule (2) à gaz, destinée notamment à être incluse dans un capteur atomique (1) tel qu'une horloge atomique, un magnétomètre atomique ou un gyromètre atomique, en étant associée d'une part, à au moins un laser (3) d'émission d'un faisceau laser (5) extérieur entrant impactant la cellule et, d'autre part, à un photodétecteur de réception (4) d'un faisceau laser extérieur sortant de la cellule, le faisceau laser ayant pénétré la cellule, la cellule comprenant une cavité optique (11) munie d'au moins une fenêtre optique (9) et apte à être emplie d'un gaz,
la cellule comprenant
- une cuvette de scellement (13) comportant
o une embouchure de cavité (14) adaptée pour permettre un passage de gaz entre la cuvette de scellement (13) et la cavité optique (11),
∘ une embouchure de canal (15) conçue pour permettre une arrivée de gaz dans la cuvette de scellement (13) par un canal d'arrivée de gaz (17), et
∘ un accès de scellage (16)
- un ensemble multicouche (6) comportant, d'une part,
• une plaquette - ou wafer - conformable (7), conformée en creux pour présenter un évidement (25) débouchant en au moins une ouverture (25a), ledit évidement étant apte à être empli d'un gaz, et, d'autre part,
• au moins une plaquette - ou wafer - en verre (8) fermant hermétiquement ladite ouverture (25a) de l'évidement (25) pour former ladite cavité optique (11) munie d'au moins une fenêtre optique (9), la plaquette - ou wafer - en verre (8) et la plaquette - ou wafer - conformée (7) en creux étant disposées en regard l'une de l'autre et scellées l'une à l'autre, en particulier par soudure anodique, et
- une membrane (18) étant une portion de la plaquette - ou wafer - en verre (8) et fermant hermétiquement l'accès de scellage de la cuvette de scellement,
la cellule étant arrangée de sorte à ce que la membrane (18) soit apte à venir fermer hermétiquement au moins l'une parmi l'embouchure de cavité (14) et l'embouchure de canal (15) lorsque ladite membrane (18) est déformée plastiquement par chauffage , de sorte à séparer hermétiquement la cavité optique (11) du canal d'arrivée de gaz (17).

2. Cellule selon la revendication 1, comprenant en outre un dispositif de chauffe (23) en contact avec la membrane (18), notamment un élément résistif apte à être parcouru par un courant électrique ou une couche d'un matériau absorbant pour au moins une longueur d'onde lumineuse qui n'est pas sensiblement absorbée par la membrane.

3. Cellule selon l'une quelconque des revendications 1 et 2, dans laquelle la fenêtre optique (9) et la membrane (18) sont formées par deux portions écartées l'une de l'autre d'une seule et même plaquette - ou wafer - en verre (8).

4. Cellule selon l'une quelconque des revendications précédentes, dans laquelle la plaquette - ou wafer - conformable (7) est conformée en creux pour présenter un deuxième évidement (26), formant la cuvette de scellement (13), et débouchant en au moins une deuxième ouverture (26a), formant l'accès de scellage (16).

5. Cellule selon l'une quelconque des revendications 1 et 3, dans laquelle la cuvette de scellement (13) et la membrane (18) sont formées dans la plaquette - ou wafer - en verre (8), en particulier dans laquelle la plaquette - ou wafer - en verre comporte au moins une première sous-couche en verre (27a) et une deuxième sous-couche en verre (27b) superposées et solidarisées, la cuvette de scellement (13) étant formée dans la première sous-couche en verre, la membrane (18) étant formée dans la deuxième sous-couche en verre.

6. Cellule selon l'une quelconque des revendications 1 et 3, dans laquelle la plaquette - ou wafer - en verre comporte une première sous-couche en verre (27a) et une deuxième sous-couche en verre (27b) et dans laquelle l'ensemble multicouche (6) comporte en outre une couche intermédiaire (27c) de scellement anodique, notamment en silicium, disposée entre la première sous-couche en verre (27a) et la deuxième sous-couche en verre (27b) de sorte à permettre une soudure anodique entre la première sous-couche en verre (27a) et la deuxième sous-couche en verre (27b),
en particulier dans laquelle
- la membrane (18) est formée dans la deuxième sous-couche en verre (27b),
- l'embouchure de cavité (14) au moins est formée dans la première sous-couche en verre (27a), et
- la couche intermédiaire (27c) de scellement anodique est mise en forme pour laisser libre au moins la fenêtre optique (9).

7. Cellule selon l'une quelconque des revendications 1 à 6, dans laquelle le canal d'arrivée de gaz (17) est formé dans l'une au moins de la plaquette - ou wafer - conformable (7) et de la plaquette - ou wafer - en verre (8), de sorte à traverser sensiblement la totalité d'une épaisseur de ladite plaquette - ou wafer -, de manière sensiblement perpendiculaire à un plan d'extension de ladite plaquette - ou wafer.

8. Cellule selon l'une quelconque des revendications 1 à 7, dans laquelle la membrane (18) est en verre, et en particulier est une portion amincie d'une plaquette - ou wafer - en verre (8).

9. Cellule selon l'une quelconque des revendications 1 à 8, dans laquelle la membrane (18) comporte une excroissance (18c) en regard de la cuvette de scellement (13), en particulier une excroissance (18c) sur la face interne (18b) de la membrane (18) s'étendant dans la cuvette de scellement (13).

10. Cellule selon l'une quelconque des revendications 1 à 9, dans laquelle la cuvette de scellement (13) comporte une zone de scellage (28) entourant l'embouchure de canal (15), sensiblement plane et parallèle à la membrane non déformée, et conçue pour venir former un contact hermétique avec la membrane déformée plastiquement par chauffage de sorte à séparer hermétiquement la cavité optique (11) du canal d'arrivée de gaz (17).

11. Cellule selon la revendication 10, dans laquelle une distance entre la membrane (18) non déformée plastiquement et la zone de scellage (28) - mesurée perpendiculairement à ladite membrane non déformée plastiquement et ladite zone de scellage - est inférieure à une centaine de microns.

12. Cellule selon l'une quelconque des revendications 10 et 11, dans laquelle un diamètre de la zone de scellage (28) de la cuvette de scellement (13) est supérieur à trois fois ladite distance entre la membrane (18) non déformée plastiquement et la zone de scellage (28) .

13. Cellule selon l'une quelconque des revendications 1 à 12, dans laquelle une épaisseur de la membrane (18) est inférieure à 500 microns, de préférence inférieure à 200 microns.

14. Cellule selon l'une quelconque des revendications 1 à 13, qui comprend une source d'un gaz (19, 19a) reliée au canal d'arrivée de gaz (17) et adaptée pour emplir la cavité optique (11) avec un gaz par l'intermédiaire du canal d'arrivée de gaz (17) et de la cuvette de scellement (13), au moyen de l'embouchure de cavité (14) et de l'embouchure de canal (15).

15. Cellule selon la revendication 14, dans laquelle la source comprend une cavité source (19) reliée au canal d'arrivée de gaz (17) et un dispenseur (19a) de métal alcalin reçu dans la cavité source et adapté pour générer une vapeur alcaline par chauffage.

16. Cellule selon l'une quelconque des revendications 1 à 15, qui comprend, outre la cavité optique (11), une cavité additionnelle (29) emplie d'un gaz additionnel, adjacente à et séparée de la cavité optique (11) par une paroi (30) conçue pour être percée et permettre un mélange dudit gaz additionnel avec un gaz contenu dans la cavité optique.

17. Cellule selon la revendication 16, dans laquelle la paroi (30) de la cavité additionnelle (29) est apte à être percée par une action sans contact exogène à la cellule (2), notamment par une interaction avec la paroi d'un faisceau laser impulsionnel, d'un faisceau laser continu ou d'une décharge électrique.

18. Cellule selon l'une quelconque des revendications 1 à 17, dans laquelle la cavité optique (11) est emplie d'un gaz, et dans laquelle la membrane (18) est dans un état déformé plastiquement dans lequel la membrane (18) ferme hermétiquement au moins l'une parmi l'embouchure de cavité (14) et l'embouchure de canal (15), en séparant hermétiquement la cavité optique (11) du canal d'arrivée de gaz (17).

19. Ensemble de cellules comportant une pluralité de cellules selon l'une quelconque des revendications 1 à 18, dont les canaux d'arrivée de gaz (17) sont reliés à une unique source de gaz (19), en particulier dans lequel ladite pluralité de cellules (2) forme un ensemble (20) solidaire et rigide adapté pour être découpé de sorte à séparer les cellules (2) les unes des autres.

20. Procédé d'emplissage de gaz d'une cellule (2), dans lequel :
- on dispose d'une cellule (2) selon l'une des revendications 1 à 18 ou d'un ensemble de cellules (20) selon la revendication 19,
- on dispose d'une source (19, 19a) d'un gaz reliée au canal d'arrivée de gaz (17) de la cellule ou de l'ensemble de cellules,
- on emplit la cavité optique (11) avec le gaz de la source par l'intermédiaire du canal d'arrivée de gaz (17) et de la cuvette de scellement (13), au moyen de l'embouchure de cavité (14) et de l'embouchure de canal (15), et
- on déforme plastiquement par chauffage la membrane (18) pour venir fermer hermétiquement au moins l'une parmi l'embouchure de cavité (14) et l'embouchure de canal (15), de sorte à séparer hermétiquement la cavité optique (11) du canal d'arrivée de gaz (17).

21. Procédé d'emplissage de gaz selon la revendication 20, dans lequel on déforme plastiquement la membrane (18) par chauffage d'une face externe (18a) de la membrane (18), ladite face externe (18a) étant en particulier une face extérieure à la cellule (2).

22. Procédé d'emplissage de gaz selon la revendication 20, dans lequel on déforme plastiquement la membrane (18) par chauffage au moyen d'un laser dirigé sur la membrane.

23. Procédé d'emplissage de gaz selon la revendication 20, dans lequel on déforme plastiquement la membrane (18) par chauffage en faisant circuler un courant électrique dans un élément résistif (23) en contact avec la membrane.

24. Procédé d'emplissage de gaz selon l'une quelconque des revendications 20 à 23, dans lequel la source est un dispenseur (19a) de métal alcalin reçu dans une cavité source (19) reliée au canal d'arrivée de gaz (17) de la cellule ou de l'ensemble de cellules, et dans lequel on emplit la cavité optique (11) en chauffant ledit dispenseur.

25. Procédé d'emplissage de gaz selon l'une quelconque des revendications 20 à 24, dans lequel, après avoir déformé plastiquement la membrane (18) pour séparer hermétiquement la cavité optique du canal d'arrivée de gaz, on sépare la cellule (2) de la source de gaz.

26. Procédé d'emplissage de gaz selon l'une quelconque des revendications 20 à 25, dans lequel, après avoir déformé plastiquement la membrane (18) pour séparer hermétiquement la cavité optique (11) du canal d'arrivée de gaz (17), on perce une paroi (30) séparant de la cavité optique (11) une cavité additionnelle (29) emplie d'un gaz additionnel, de sorte à mélanger ledit gaz additionnel avec un gaz contenu dans la cavité optique.

27. Procédé d'emplissage de gaz selon l'une quelconque des revendications 20 à 26, dans lequel on dispose d'un ensemble de cellules (20) selon la revendication 18, et dans lequel, après avoir emplit la cavité optique (11) avec le gaz de la source,
- on porte au moins les cavités de gaz (11) des cellules (2) de l'ensemble de cellules (20) à une température supérieure à une première température prédéfinie, ladite première température prédéfinie étant supérieure à une température de fonctionnement des cellules (2) de l'ensemble de cellules (20) et on porte une région froide (40) de l'ensemble de cellules (20) à une deuxième température prédéfinie, strictement inférieure à la première température prédéfinie,
- on déforme plastiquement par chauffage la membrane (18) de chaque cellule (2) de l'ensemble de cellules (20) en maintenant les températures des cavités de gaz (11) des cellules (2) et de la région froide (40) de l'ensemble de cellules (20), et
- on refroidit les cavité de gaz (11) des cellules (2) de l'ensemble de cellules (20) à la température de fonctionnement desdites cellules (2).

28. Procédé de mise sous vide d'une cellule, dans lequel :
- on dispose d'une cellule (2) selon l'une des revendications 1 à 18 ou d'un ensemble de cellules (20) selon la revendication 19,
- on dispose d'une station de pompage (31) reliée au canal d'arrivée de gaz (17) de la cellule ou de l'ensemble de cellules,
- on actionne la station de pompage (31) pour aspirer un gaz contenu dans la cavité optique (11) par l'intermédiaire du canal d'arrivée de gaz (17) et de la cuvette de scellement (13), au moyen de l'embouchure de cavité (14) et de l'embouchure de canal (15), et
- on déforme plastiquement par chauffage la membrane (18) pour venir fermer hermétiquement au moins l'une parmi l'embouchure de cavité (14) et l'embouchure de canal (15), de sorte à séparer hermétiquement la cavité optique (11) du canal d'arrivée de gaz (17).

29. Procédé de fabrication d'une cellule selon l'une des revendications 1 à 18 dans lequel
- on dispose d'une plaquette - ou wafer - conformable (7) et d'au moins au moins une plaquette - ou wafer - en verre (8),
- on conforme en creux la plaquette - ou wafer - conformable, en particulier on la grave, pour former un évidement (25) débouchant en au moins une ouverture (25a),
- on conforme au moins l'une parmi la plaquette - ou wafer - conformable (7) et la plaquette - ou wafer - en verre (8), en particulier on la grave, de sorte à former un canal d'arrivée de gaz (17) et une cuvette de scellement (13) comportant
∘ une embouchure de cavité (14) adaptée pour permettre un passage de gaz entre la cuvette de scellement (13) et la cavité optique (11),
∘ une embouchure de canal (15) conçue pour permettre une arrivée de gaz dans la cuvette de scellement (13) par le canal d'arrivée de gaz (17), et
∘ un accès de scellage (16),
- on forme un ensemble multicouche (6) comportant la plaquette - ou wafer - conformable (7) et ladite au moins au moins une plaquette - ou wafer - en verre (8) de sorte que
∘ on ferme hermétiquement l'ouverture (25a) de l'évidement (25) pour former ladite cavité optique (11) munie d'au moins une fenêtre optique (9) et apte à être emplie d'un gaz, et
∘ on ferme hermétiquement l'accès de scellage (16) avec une membrane (18) étant une portion de la plaquette - ou wafer- en verre (8), et étant apte à être déformée plastiquement par chauffage pour venir fermer hermétiquement au moins l'une parmi l'embouchure de cavité (14) et l'embouchure de canal (15), de sorte à séparer hermétiquement la cavité optique (11) du canal d'arrivée de gaz (17).

30. Capteur atomique (1) comprenant une cellule (2) selon l'une quelconque des revendications 1 à 18, associée, de façon compacte, d'une part, à un laser (3) d'émission d'un faisceau laser (5) extérieur entrant impactant la cellule et, d'autre part, à un photodétecteur de réception (4) d'un faisceau laser extérieur sortant de la cellule.

## Patentansprüche

1. Gaszelle (2), insbesondere bestimmt zum Einschließen in einen Atomsensor (1) wie eine Atomuhr, ein Atommagnetometer oder ein Atomgyrometer, durch Assoziation einerseits mit mindestens einem Laser (3) zum Emittieren eines ankommenden äußeren Laserstrahls (5), der auf die Zelle auftrifft, und andererseits mit einem Photodetektor (4) zum Empfangen eines äußeren Laserstrahls, der aus der Zelle austritt, wobei der Laserstrahl in die Zelle eingedrungen ist, wobei die Zelle einen optischen Hohlraum (11) umfasst, der mit mindestens einem optischen Fenster (9) versehen ist und mit einem Gas gefüllt werden kann,
wobei die Zelle Folgendes umfasst:
- eine Dichtungsschüssel (13) mit
∘ einer Hohlraummündung (14), adaptiert zum Zulassen eines Durchflusses von Gas zwischen der Dichtungsschüssel (13) und dem optischen Hohlraum (11),
∘ einer Kanalmündung (15), ausgelegt zum Zulassen des Eintritts von Gas über einen Gaseinlasskanal (17) in die Dichtungsschüssel (13), und
∘ einen Dichtungszugang (16),
- eine mehrschichtige Anordnung (6), die einerseits Folgendes aufweist:
• eine(n) anpassungsfähige(n) Scheibe oder Wafer (7), die/der hohl ausgebildet wird, so dass sie eine Aussparung (25) aufweist, die in mindestens eine Öffnung (25a) mündet, wobei die Aussparung mit einem Gas gefüllt werden kann, und andererseits
• mindestens eine(n) Glasscheibe oder -wafer (8), die/der die Öffnung (25a) der Aussparung (25) abdichtet, um den optischen Hohlraum (11) zu bilden, der mit mindestens einem optischen Fenster (9) versehen ist, wobei die/der Glasscheibe oder - wafer (8) und die/der ausgehöhlte Scheibe oder Wafer (7) einander gegenüberliegend angeordnet und gegeneinander abgedichtet sind, insbesondere durch anodisches Schweißen, und
- eine Membran (18), die ein Teil der/des Glasscheibe oder -wafers ist und den Dichtungszugang der Dichtungsschüssel abdichtet,
wobei die Zelle so angeordnet ist, dass die Membran (18) die Hohlraummündung (14) und/oder die Kanalmündung (15) abdichten kann, wenn die Membran (18) durch Erhitzen plastisch verformt wird, so dass der optische Hohlraum (11) vom Gaseinlasskanal (17) hermetisch getrennt wird.

2. Zelle nach Anspruch 1, die ferner eine Heizvorrichtung (23) in Kontakt mit der Membran (18), insbesondere ein Widerstandselement, durch das ein elektrischer Strom fließen kann, oder eine Schicht aus einem Material, das für mindestens eine Lichtwellenlänge absorbierend ist, die von der Membran nicht wesentlich absorbiert wird, umfasst.

3. Zelle nach einem der Ansprüche 1 und 2, wobei das optische Fenster (9) und die Membran (18) durch zwei voneinander beabstandete Teile einer/s einzigen Glasscheibe oder -wafers (8) gebildet sind.

4. Zelle nach einem der vorherigen Ansprüche, wobei die/der anpassungsfähige Scheibe oder Wafer (7) hohl ausgebildet ist, so dass er eine zweite Aussparung (26) aufweist, die die Dichtungsschüssel (13) bildet und in mindestens eine zweite Öffnung (26a) mündet, die den Dichtungszugang (16) bildet.

5. Zelle nach einem der Ansprüche 1 und 3, wobei die Dichtungsschüssel (13) und die Membran (18) in der/dem Glasscheibe oder -wafer (8) ausgebildet sind, wobei insbesondere die/der Glasscheibe oder -wafer mindestens eine erste Glasunterschicht (27a) und eine zweite Glasunterschicht (27b) aufweist, die übereinander liegen und fest aneinander gebunden sind, wobei die Dichtungsschüssel (13) in der ersten Glasunterschicht ausgebildet ist, wobei die Membran (18) in der zweiten Glasunterschicht ausgebildet ist.

6. Zelle nach einem der Ansprüche 1 und 3, wobei die/der Glasscheibe oder -wafer eine erste Glasunterschicht (27a) und eine zweite Glasunterschicht (27b) aufweist und wobei die Mehrschichtanordnung (6) ferner eine anodische Zwischenabdichtungsschicht (27c), insbesondere aus Silicium, aufweist, die zwischen der ersten Glasunterschicht (27a) und der zweiten Glasunterschicht (27b) angeordnet ist, um eine anodische Schweißung zwischen der ersten Glasunterschicht (27a) und der zweiten Glasunterschicht (27b) zuzulassen,
wobei insbesondere
- die Membran (18) in der zweiten Glasunterschicht (27b) ausgebildet ist,
- mindestens die Hohlraummündung (14) in der ersten Glasunterschicht (27a) ausgebildet ist, und
- die anodische Zwischenabdichtungsschicht (27c) so geformt ist, dass mindestens das optische Fenster (9) frei bleibt.

7. Zelle nach einem der Ansprüche 1 bis 6, wobei der Gaseinlasskanal (17) in der/dem anpassungsfähige(n) Scheibe oder Wafer (7) und/oder der/dem Glasscheibe oder -wafer (8) ausgebildet ist, so dass er im Wesentlichen die Gesamtheit einer Dicke des Wafers im Wesentlichen lotrecht zu einer Erstreckungsebene der/des Scheibe oder Wafers durchläuft.

8. Zelle nach einem der Ansprüche 1 bis 7, wobei die Membran (18) aus Glas besteht und insbesondere ein verdünnter Teil einer/s Glasscheibe oder -wafers (8) ist.

9. Zelle nach einem der Ansprüche 1 bis 8, wobei die Membran (18) einen Vorsprung (18c) gegenüber der Dichtungsschüssel (13), insbesondere einen Vorsprung (18c) auf der Innenseite (18b) der Membran (18) aufweist, der sich in die Dichtungsschüssel (13) erstreckt.

10. Zelle nach einem der Ansprüche 1 bis 9, wobei die Dichtungsschüssel (13) eine Dichtungszone (28) aufweist, die die Kanalmündung (15) umgibt, im Wesentlichen planar und parallel zu der unverformten Membran und zum Herstellen eines hermetischen Kontakts mit der plastisch wärmeverformten Membran gestaltet ist, um den optischen Hohlraum (11) hermetisch von dem Gaseinlasskanal (17) zu trennen.

11. Zelle nach Anspruch 10, wobei ein Abstand zwischen der nicht plastisch verformten Membran (18) und der Dichtungszone (28) - gemessen lotrecht zu der nicht plastisch verformten Membran und der Dichtungszone - weniger als hundert Mikrometer beträgt.

12. Zelle nach einem der Ansprüche 10 und 11, wobei ein Durchmesser der Dichtungszone (28) der Dichtungsschüssel (13) größer ist als das Dreifache des Abstands zwischen der nicht plastisch verformten Membran (18) und der Dichtungszone (28).

13. Zelle nach einem der Ansprüche 1 bis 12, wobei eine Dicke der Membran (18) weniger als 500 Mikrometer, vorzugsweise weniger als 200 Mikrometer beträgt.

14. Zelle nach einem der Ansprüche 1 bis 13, die eine Gasquelle (19, 19a) umfasst, die mit dem Gaseinlasskanal (17) verbunden und zum Füllen des optischen Hohlraums (11) über den Gaseinlasskanal (17) und die Dichtungsschüssel (13) mittels der Hohlraummündung (14) und der Kanalmündung (15) mit einem Gas adaptiert ist.

15. Zelle nach Anspruch 14, wobei die Quelle einen mit dem Gaseinlasskanal (17) verbundenen Quellenhohlraum (19) und einen Alkalimetallspender (19a) umfasst, der im Quellenhohlraum aufgenommen und zum Erzeugen von Alkalidampf durch Erhitzen adaptiert ist.

16. Zelle nach einem der Ansprüche 1 bis 15, die zusätzlich zu dem optischen Hohlraum (11) einen mit einem zusätzlichen Gas gefüllten zusätzlichen Hohlraum (29) neben dem optischen Hohlraum (11) und von diesem durch eine Wand (30) getrennt umfasst, die zum Durchstoßen ausgelegt ist und das Mischen des zusätzlichen Gases mit einem im optischen Hohlraum enthaltenen Gas zulässt.

17. Zelle nach Anspruch 16, wobei die Wand (30) des zusätzlichen Hohlraums (29) durch eine von der Zelle (2) ausgehende berührungslose Wirkung, insbesondere durch eine Wechselwirkung eines gepulsten Laserstrahls, eines kontinuierlichen Laserstrahls oder einer Elektronenentladung mit der Wand durchstoßen werden kann.

18. Zelle nach einem der Ansprüche 1 bis 17, wobei der optische Hohlraum (11) mit einem Gas gefüllt ist und wobei die Membran (18) in einem plastisch verformten Zustand ist, in dem die Membran (18) mindestens eine aus der Hohlraummündung (14) und der Kanalmündung (15) durch hermetische Trennung der optische Hohlraum (11) von dem Gaseinlasskanal (17) abdichtet.

19. Zellenanordnung mit einer Mehrzahl von Zellen nach einem der Ansprüche 1 bis 18, deren Gaseinlasskanäle (17) mit einer einzigen Gasquelle (19) verbunden sind, wobei insbesondere die Mehrzahl von Zellen (2) eine integrale und starre Anordnung (20) bilden, die so abgeschnitten werden kann, dass die Zellen (2) voneinander getrennt werden.

20. Verfahren zum Füllen einer Zelle (2) mit Gas, wobei:
- eine Zelle (2) nach einem der Ansprüche 1 bis 18 oder eine Anordnung von Zellen (20) nach Anspruch 19 vorgesehen wird,
- eine Gasquelle (19, 19a) vorgesehen wird, die mit dem Gaseinlasskanal (17) der Zelle oder der Anordnung von Zellen verbunden ist,
- der optische Hohlraum (11) über den Gaseinlasskanal (17) und die Dichtungsschüssel (13) mit Hilfe der Hohlraummündung (14) und der Kanalmündung (15) mit dem Gas der Quelle gefüllt wird, und
- die Membran (18) durch Erwärmen plastisch verformt wird, um mindestens eine aus der Hohlraummündung (14) und der Kanalmündung (15) abzudichten, um den optischen Hohlraum (11) hermetisch von dem Gaseinlasskanal (17) zu trennen.

21. Gaseinfüllverfahren nach Anspruch 20, wobei die Membran (18) durch Erwärmen einer Außenseite (18a) der Membran (18) plastisch verformt wird, wobei die Außenseite (18a) insbesondere eine Seite außerhalb der Zelle (2) ist.

22. Gaseinfüllverfahren nach Anspruch 20, wobei die Membran (18) durch Erwärmen mittels eines auf die Membran gerichteten Lasers plastisch verformt wird.

23. Gaseinfüllverfahren nach Anspruch 20, wobei die Membran (18) durch Erwärmen plastisch verformt wird, indem ein elektrischer Strom durch ein Widerstandselement (23) in Kontakt mit der Membran geleitet wird.

24. Gaseinfüllverfahren nach einem der Ansprüche 20 bis 23, wobei die Quelle ein Alkalimetallspender (19a) ist, der in einem mit dem Gaseinlasskanal (17) der Zelle oder der Anordnung von Zellen verbundenen Quellenhohlraum (19) aufgenommen ist, und wobei der optische Hohlraum (11) durch Erhitzen des Spenders gefüllt wird.

25. Gaseinfüllverfahren nach einem der Ansprüche 20 bis 24, wobei die Zelle (2) nach plastischer Verformung der Membran (18) zum hermetischen Trennen des optischen Hohlraums vom Gaseinlasskanal von der Gasquelle getrennt wird.

26. Gaseinfüllverfahren nach einem der Ansprüche 20 bis 25, wobei nach plastischer Verformung der Membran (18) zum hermetischen Trennen des optischen Hohlraums (11) von dem Gaseinlasskanal (17) eine Wand (30), die einen mit einem zusätzlichen Gas gefüllten zusätzlichen Hohlraum (29) von dem optischen Hohlraum (11) trennt, durchstoßen wird, um das zusätzliche Gas mit einem in dem optischen Hohlraum enthaltenen Gas zu mischen.

27. Gaseinfüllverfahren nach einem der Ansprüche 20 bis 26, wobei eine Anordnung von Zellen (20) nach Anspruch 18 bereitgestellt wird und wobei nach dem Füllen des optischen Hohlraums (11) mit dem Quellgas,
- mindestens die Gashohlräume (11) der Zellen (2) der Zellenanordnung (20) auf eine Temperatur oberhalb einer ersten vordefinierten Temperatur aufgeheizt werden, wobei die erste vordefinierte Temperatur höher ist als eine Betriebstemperatur der Zellen (2) der Zellenanordnung (20), und ein kalter Bereich (40) der Zellenanordnung (20) auf eine zweite vordefinierte Temperatur aufgeheizt wird, die strikt niedriger ist als die erste vordefinierte Temperatur,
- die Membran (18) jeder Zelle (2) der Zellenanordnung (20) durch Erwärmen plastisch verformt wird, während die Temperaturen der Gashohlräume (11) der Zellen (2) und des kalten Bereichs (40) der Zellenanordnung (20) beibehalten werden, und
- die Gashohlräume (11) der Zellen (2) der Zellenanordnung (20) auf die Betriebstemperatur der Zellen (2) gekühlt werden.

28. Verfahren zum Evakuieren einer Zelle, wobei:
- eine Zelle (2) nach einem der Ansprüche 1 bis 18 oder eine Zellenanordnung (20) nach Anspruch 19 vorgesehen wird,
- eine Pumpstation (31) vorgesehen wird, die mit dem Gaseinlasskanal (17) der Zelle oder der Zellenanordnung verbunden ist,
- die Pumpstation (31) betrieben wird, um ein in dem optischen Hohlraum (11) enthaltenes Gas über den Gaseinlasskanal (17) und die Dichtungsschüssel (13) mittels der Hohlraummündung (14) und der Kanalmündung (15) anzusaugen, und
- die Membran (18) durch Erwärmen plastisch verformt wird, um die Hohlraummündung (14) und/oder die Kanalmündung (15) abzudichten, um den optischen Hohlraum (11) hermetisch vom Gaseinlasskanal (17) zu trennen.

29. Verfahren zur Herstellung einer Zelle nach einem der Ansprüche 1 bis 18, wobei:
- ein(e) anpassungsfähige(r) Scheibe oder Wafer (7) und mindestens ein(e) Glasscheibe oder -wafer (8) vorgesehen werden,
- die/der anpassungsfähige Scheibe oder Wafer (7) so geformt, insbesondere geätzt wird, dass sie/er eine Aussparung (25) bildet, die in mindestens eine Öffnung (25a) mündet,
- die/der anpassungsfähige Scheibe oder Wafer (7) und/oder die/der Glasscheibe oder -wafer (8) so geformt, insbesondere geätzt wird, dass ein Gaseinlasskanal (17) und eine Dichtungsschüssel (13) gebildet werden mit
∘ einer Hohlraummündung (14), adaptiert zum Zulassen des Durchflusses von Gas zwischen der Dichtungsschüssel (13) und dem optischen Hohlraum (11),
∘ einer Kanalmündung (15), ausgelegt zum Zulassen des Eintritts von Gas durch den Gaseinlasskanal (17) in die Dichtungsschüssel (13), und
∘ einem Dichtungszugang (16),
- eine mehrschichtige Anordnung (6) gebildet wird, die die/den anpassungsfähige(n) Scheibe oder Wafer (7) und die/den mindestens eine(n) Glasscheibe oder -wafer (8) umfasst, so dass
∘ die Öffnung (25a) der Aussparung (25) abgedichtet wird, um den optischen Hohlraum (11) zu bilden, der mit mindestens einem optischen Fenster (9) versehen und zum Füllen mit einem Gas geeignet ist, und
∘ der Dichtungszugang (16) mit einer Membran (18) abgedichtet wird, die ein Teil der/des Glasscheibe oder -wafers (8) ist und durch Erhitzen plastisch verformt werden kann, um die Hohlraummündung (14) und/oder die Kanalmündung (15) abzudichten, um den optischen Hohlraum (11) hermetisch vom Gaseinlasskanal (17) zu trennen.

30. Atomsensor (1) umfassend eine Zelle (2) nach einem der Ansprüche 1 bis 18, die in kompakter Weise einerseits mit einem Laser (3) zum Emittieren eines ankommenden äußeren Laserstrahls (5), der auf die Zelle auftrifft, und andererseits mit einem Photodetektor (4) zum Empfangen eines von der Zelle abgehenden äußeren Laserstrahls assoziiert ist.

## Claims

1. Gas cell (2), in particular for inclusion in an atomic sensor (1) such as an atomic clock, an atomic magnetometer, or an atomic gyro, being associated on one hand with at least one laser (3) emitting an incoming exterior laser beam (5) striking the cell and, on the other hand, with a photodetector (4) for receiving an exterior laser beam exiting the cell, the laser beam having penetrated the cell, the cell comprising an optical cavity (11) provided with at least one optical window (9) and capable of being filled with a gas,
the cell comprising
- a sealing basin (13) having
∘ a cavity mouth (14) adapted to allow a passage of gas between the sealing basin (13) and the optical cavity (11),
∘ a channel mouth (15) designed to allow gas to enter the sealing basin (13) via a gas inflow channel (17), and
∘ a sealing access (16),
- a multilayer assembly (6) having, on one hand,
• a shapeable plate or wafer (7) hollow-shaped such that it has a recess (25) opening into at least one opening (25a), wherein said recess can be filled with a gas, and, on the other hand;
• at least one glass plate or wafer (8) hermetically closing said opening (25a) of the recess (25) to form the optical cavity (11) provided with at least one optical window (9), the glass plate or wafer (8) and the hollow-shaped plate or wafer (7) being arranged facing one another and sealed to one another, in particular by anodic bonding, and
- a membrane (18) being a part of the glass plate or wafer (8) and hermetically closing the sealing access of the sealing basin,
the cell being arranged such that the membrane (18) can hermetically close at least one of the cavity mouth (14) and the channel mouth (15) when said membrane (18) is plastically deformed by heating, in such a way as to hermetically separate the optical cavity (11) from the gas inflow channel (17).

2. Cell according to claim 1, further comprising a heating device (23) in contact with the membrane (18), in particular a resistive element that can be traversed by an electric current or a layer of a material that is absorbent to at least one wavelength of light which is not substantially absorbed by the membrane.

3. Cell according to any one of claims 1 and 2, wherein the optical window (9) and the membrane (18) are formed by two portions, separated from one another, of a single glass plate or wafer (8).

4. Cell according to any one of the preceding claims, wherein the shaped plate or wafer (7) is hollow-shaped such that it has a second recess (26), forming the sealing basin (13), and opening into at least a second opening (26a), forming the sealing access (16).

5. Cell according to any one of claims 1 and 3, wherein the sealing basin (13) and the membrane (18) are formed in the glass plate or wafer (8), in particular wherein the glass plate or wafer has at least a first glass sub-layer (27a) and a second glass sub-layer (27b) which are superimposed and integrally secured, the sealing basin (13) being formed in the first glass sub-layer, the membrane (18) being formed in the second glass sub-layer.

6. Cell according to any one of claims 1 and 3, wherein the glass plate or wafer has a first glass sub-layer (27a) and a second glass sub-layer (27b) and wherein the multilayer assembly (6) further has an intermediate layer (27c) for anodic sealing, in particular of silicon, arranged between the first glass sub-layer (27a) and the second glass sub-layer (27b) so as to enable anodic bonding between the first glass sub-layer (27a) and the second sub-glass layer (27b),
in particular wherein
- the membrane (18) is formed in the second glass sub-layer (27b),
- at least the cavity mouth (14) is formed in the first glass sub-layer (27a), and
- the intermediate layer (27c) for anodic sealing is shaped to leave at least the optical window (9) unobstructed.

7. Cell according to any one of claims 1 to 6, wherein the gas inflow channel (17) is formed in at least one among the shapeable plate or wafer (7) and the glass plate or wafer (8), so as to substantially traverse the totality of a thickness of said plate or wafer, in a manner substantially perpendicular to a plane of extension of said plate or wafer.

8. Cell according to any one of claims 1 to 7, wherein the membrane (18) is made of glass, and in particular is a thinned portion of a glass plate or wafer (8).

9. Cell according to any one of claims 1 to 8, wherein the membrane (18) has a protrusion (18c) facing the sealing basin (13), in particular a protrusion (18c) on the inner face (18b) of the membrane (18), extending into the sealing basin (13).

10. Cell according to any one of claims 1 to 9, wherein the sealing basin (13) has a sealing area (28) surrounding the channel mouth (15), substantially planar and parallel to the non-deformed membrane, and designed to form a hermetic contact with the membrane plastically deformed by heating so as to hermetically separate the optical cavity (11) from the gas inflow channel (17).

11. Cell according to claim 10, wherein a distance between the non-plastically deformed membrane (18) and the sealing area (28) -measured perpendicularly to said non-plastically deformed membrane and said sealing area- is less than a hundred microns.

12. Cell according to any one of claims 10 and 11, wherein a diameter of the sealing area (28) of the sealing basin (13) is greater than three times said distance between the non-plastically deformed membrane (18) and the sealing area (28).

13. Cell according to any one of claims 1 to 12, wherein a thickness of the membrane (18) is less than 500 microns, preferably less than 200 microns.

14. Cell according to any one of claims 1 to 13, comprising a gas source (19, 19a) connected to the gas inflow channel (17) and adapted to fill the optical cavity (11) with a gas via the gas inflow channel (17) and the sealing basin (13), by means of the cavity mouth (14) and the channel mouth (15).

15. Cell according to claim 14, wherein the source comprises a source cavity (19) connected to the gas inflow channel (17) and a dispenser (19a) of alkali metal received in the source cavity and adapted to generate alkali vapor by heating.

16. Cell according to any one of claims 1 to 15, comprising, in addition to the optical cavity (11), an additional cavity (29) filled with an additional gas and adjacent to the optical cavity (11) and separated therefrom by a wall (30) designed to be pierced and to enable mixing said additional gas with a gas contained within the optical cavity.

17. Cell according to claim 16, wherein the wall (30) of the additional cavity (29) can be pierced by a contactless action exogenous to the cell (2), in particular by interaction of a pulsed laser beam, a continuous laser beam, or an electric discharge, with the wall.

18. Cell according to any one of claims 1 to 17, wherein the optical cavity (11) is filled with a gas, and wherein the membrane (18) is in a plastically deformed state in which the membrane (18) hermetically closes at least one among the cavity mouth (14) and the channel mouth (15), by hermetically separating the optical cavity (11) from the gas inflow channel (17).

19. Set of cells having a plurality of cells according to any one of claims 1 to 18, the gas inflow channels (17) of which are connected to a single gas source (19), in particular wherein said plurality of cells (2) forms an integral and rigid assembly (20) that can be cut so as to separate the cells (2) from one another.

20. Method for filling a cell (2) with gas, wherein:
- a cell (2) according to one of claims 1 to 18 or a set of cells (20) according to claim 19 is provided,
- a gas source (19, 19a) connected to the gas inflow channel (17) of the cell or set of cells is provided,
- the optical cavity (11) is filled with gas from the source via the gas inflow channel (17) and the sealing basin (13), by means of the cavity mouth (14) and the channel mouth (15), and
- the membrane (18) is plastically deformed by heating to hermetically close at least one among the cavity mouth (14) and the channel mouth (15), in such a way that it hermetically separates the optical cavity (11) from the gas inflow channel (17).

21. Gas filling method according to claim 20, wherein the membrane (18) is plastically deformed by heating an outer face (18a) of the membrane (18), said outer face (18a) being in particular a face external to the cell (2).

22. Gas filling method according to claim 20, wherein the membrane (18) is plastically deformed by heating by means of a laser directed onto the membrane.

23. Gas filling method according to claim 20, wherein the membrane (18) is plastically deformed by heating, by making an electric current flow through a resistive element (23) in contact with the membrane.

24. Gas filling method according to any one of claims 20 to 23, wherein the source is a dispenser (19a) of alkali metal received within a source cavity (19) connected to the gas inflow channel (17) of the cell or set of cells, and wherein the optical cavity is filled (11) by heating said dispenser.

25. Gas filling method according to any one of claims 20 to 24, wherein, after the membrane (18) is plastically deformed in order to hermetically separate the optical cavity from the gas inflow channel, the cell is detached (2) from the gas source.

26. Gas filling method according to any one of claims 20 to 25, wherein, after the membrane (18) is plastically deformed in order to hermetically separate the optical cavity (11) from the gas inflow channel (17), a wall (30), separating the optical cavity (11) from an additional cavity (29) filled with an additional gas, is pierced so as to mix said additional gas with a gas contained within the optical cavity.

27. Gas filling method according to any one of claims 20 to 26, wherein a set of cells (20) according to claim 18 is provided, and wherein, after having filled the optical cavity (11) with the gas from the source,
- at least the gas cavities (11) of the cells (2) of the set of cells (20) are brought to a temperature above a first predefined temperature, said first predefined temperature being greater than a operating temperature of the cell (2) of the set of cells (20), and a cold region (40) of the set of cells (20) is brought to a second predefined temperature that is strictly less than the first predefined temperature,
- the membrane (18) of each cell (2) of the set of cells (20) is plastically deformed by heating while maintaining the temperatures of the gas cavities (11) of the cells (2) and of the cold region (40) of the set of cells (20), and
- the gas cavities (11) of the cells (2) of the set of cells (20) are cooled to the operating temperature of said cells (2).

28. Method for creating a vacuum in a cell, wherein:
- a cell (2) according to one of claims 1 to 18 or a set of cells (20) according to claim 19 is provided,
- a pumping station (31) connected to the gas inflow channel (17) of the cell or set of cells is provided,
- the pumping station (31) is operated so as to suction a gas contained in the optical cavity (11) via the gas inflow channel (17) and the sealing basin (13), by means of the cavity mouth (14) and the channel mouth (15), and
- the membrane (18) is plastically deformed by heating so as to hermetically close at least one among the cavity mouth (14) and the channel mouth (15), in such a way as to hermetically separate the optical cavity (11) from the gas inflow channel (17).

29. Method for fabricating a cell according to one of claims 1 to 18, wherein
- a shapeable plate or wafer (7) and at least one glass plate or wafer (8) is provided,
- the shapeable plate or wafer is shaped, in particular is etched, to form a recess (25) opening into at least one opening (25a),
- at least one among the shapeable plate or wafer (7) and the glass plate or wafer (8) is shaped, in particular etched, so as to form a gas inflow channel (17) and a sealing basin (13) having
∘ a cavity mouth (14) adapted to allow the passage of gas between the sealing basin (13) and the optical cavity (11),
∘ a channel mouth (15) designed to allow gas to enter the sealing basin (13) via the gas inflow channel (17), and
∘ a sealing access (16),
- a multilayer assembly (6) comprising the shapeable plate or wafer (7) and said at least one glass plate or wafer (8) is formed, such that
∘ the opening (25a) of the recess (25) is hermetically closed to form the optical cavity (11) having at least one optical window (9) and adapted to be filled with a gas, and
∘ the sealing access (16) is hermetically closed with a membrane (18) being a part of the glass plate or wafer (8), and can be plastically deformed by heating so as to hermetically close at least one among the cavity mouth (14) and the channel mouth (15), so as to hermetically separate the optical cavity (11) from the gas inflow channel (17).

30. Atomic sensor (1) comprising a cell (2) according to any one of claims 1 to 18, associated in a compact manner on the one hand with a laser (3) emitting an incoming exterior laser beam (5) striking the cell, and on the other hand with a photodetector (4) for receiving an exterior laser beam exiting the cell.
